(19) **Europäisches Patentamt**
**European Patent Office**
**Office européen des brevets**

(11) **EP 4 607 796 A1**

(12) **EUROPEAN PATENT APPLICATION**

(43) Date of publication:
27.08.2025 Bulletin 2025/35

(51) International Patent Classification (IPC):
*H03K 17/10* (2006.01)    *H03K 17/687* (2006.01)
*H03K 17/693* (2006.01)

(21) Application number: 25159211.9

(22) Date of filing: 20.02.2025

(52) Cooperative Patent Classification (CPC):
**H03K 17/693; H03K 17/102; H03K 17/6872;**
H03K 2217/0018; H03K 2217/0054

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 23.02.2024 US 202418586378
31.12.2024 US 202419007325
12.02.2025 US 202519052039

(71) Applicant: **Analog Devices International
Unlimited Company
Limerick (IE)**

(72) Inventors:
• **SANTILLAN, Jofrey**
**Co. Limerick (IE)**
• **AHERNE, David**
**Co. Limerick (IE)**
• **MCDONAGH, Declan**
**Co. Limerick (IE)**

(74) Representative: **Yang, Shu**
**Withers & Rogers LLP
2 London Bridge
London SE1 9RA (GB)**

(54) **SOLID STATE SWITCH AND A CIRCUIT**

(57)     A solid state switch, comprising a first field-effect transistor (FET). The first FET has a first terminal, a second terminal, a bulk terminal and a gate terminal, and is configured to be switched between an on-state and an off-state. The solid state switch also comprises a second FET in series with the first FET. The second FET has a first terminal, a second terminal, a bulk terminal, and a gate terminal. The second terminal of the first FET is connected to the second terminal of the second FET. The solid state switch comprises a first buffer comprises an output terminal coupled to the bulk terminal of the first FET, and an input terminal coupled to the first terminal of the first FET.

FIG. 3

# EP 4 607 796 A1

**Description**

FIELD

This application relates to compensating for leakage in a semiconductor switch (i.e. a solid state switch). Specifically, a field-effect-transistor (FET), e.g., a JFET, Silicon Carbide FET, or a low voltage FET, such as a FET with an accessible bulk (also called 'body', or 'back-gate') terminal.

BACKGROUND

Solid state switches may be used with components such as, a precision measurement apparatus, and automated test equipment. A solid state switch can have an associated leakage which affects the results at a precision measurement apparatus. For example, a large leakage current can reduce power efficiency and reduces the accuracy of component measurements connected via a solid state switch. Leakage reduction herein refers to reducing the current leakage at an input and/or output terminal of a solid state switch.

A Junction FET (JFET) is a type of transistor that controls current flow through an electric field applied to a gate. JFETs comprise a channel of either N-type or P-type semiconductor material, with the current flow controlled by a voltage applied to the gate, which forms a p-n junction with the channel. JFETs are characterized by their high input impedance and low noise, making them suitable for applications in analog signal processing and amplification.

A Silicon Carbide FET (SiC) is a type of transistor that employs silicon carbide as the semiconductor material. SiC's high breakdown voltage allows efficient operation at high temperatures and voltages compared to traditional silicon-based transistors.

SUMMARY OF THE DISCLOSURE

The present disclosure provides a solid state switch device which compensates for current leakage. In particular, the examples herein provide leakage compensation techniques which are suitable with non-isolated and fully isolated (e.g., a silicon-on-insulator (SOI), or buried oxide isolated device) switches. In addition, the examples herein also provide an area efficient implementation. Such solid state switch devices are suitable for use with AC and/or DC voltage precision measurement apparatuses and AC and/or DC automated test equipment.

According to a first aspect there is provided a solid state switch, comprising:

a first field-effect transistor, FET, comprising: a first terminal, a second terminal, a bulk terminal and a gate terminal, and configured to be switched between an on-state and an off-state;
a second FET in series with the first FET, wherein the second FET comprises a first terminal, a second terminal, a bulk terminal, and a gate terminal, and wherein the second terminal of the first FET is connected to the second terminal of the second FET; and,
a first buffer comprising an output terminal coupled to the bulk terminal of the first FET, and an input terminal coupled to the first terminal of the first FET.

Optionally, the first terminal is a drain terminal. Optionally, the second terminal is a source terminal. Optionally, the first buffer is arranged to provide a current source to the bulk terminal of the first FET.

Optionally, the first buffer is: a unity gain buffer, UGB; a voltage follower; or a cascade complementary source follower.

Optionally, the first aspect further comprises a second buffer comprising an output terminal coupled to the bulk terminal of the second FET, and an input terminal coupled to the first terminal of the second FET. Optionally, the second buffer is arranged to provide a current source to the bulk terminal of the second FET.

Optionally, the second buffer is: a unity gain buffer, UGB; a voltage follower; or a cascade complementary source follower.

Optionally, the first buffer is a UGB so as to reduce leakage at the first terminal of the first FET.

Optionally, the first FET is a low voltage FET, and optionally the second FET is a low voltage FET. Optionally, a low voltage FET is a FET arranged to be used with voltage differences of less than or equal to 5V, i.e., voltage rated at 5V.

Optionally, the first FET is an isolated FET, and the second FET is an isolated FET.

Optionally, the first terminal of the first FET is a drain terminal. Optionally, the first terminal of the second FET is a drain terminal. Optionally, the second terminal of the first FET is a source terminal. Optionally, the second terminal of the second FET is a source terminal.

Optionally, the first and second FET are both a first-type FET. Optionally, the first-type is n-type or p-type.

Optionally, the first aspect further comprises an electrical component for overvoltage protection. Optionally, the electrical component is arranged in series between the first and second FETs.

Optionally, the electrical component is a third FET. Optionally, the third FET is a second-type FET. Optionally, the second-type is p-type or n-type. Optionally, the first-type is different to the second-type. Optionally, the first, second, and third FETs have the same voltage rating.

Optionally, the electrical component protects the solid state switch in applications where overvoltage conditions can cause damage to a device to which the switch is connected.

Optionally, the solid state switch of the first aspect is a transmission-gate switch comprising the first FET in parallel with a third FET. Optionally, the third FET, comprises: a first terminal; a second terminal; a bulk terminal; and, a gate terminal, and the third FET is configured to be switched between an on-state and an off-state. Optionally, the third FET is a first-type FET. Optionally, the first FET is a second-type FET. Optionally, the first-type is n-type or p-type. Optionally, the second-type is p-type or n-type. Optionally, the first-type is different to the second-type.

Optionally, the first terminal of the third FET is coupled to the first terminal of the first FET, and the second terminal of the third FET is coupled to the first terminal of the second FET.

Optionally, the first terminal of the third FET is coupled to the first terminal of the first FET, and the second terminal of the third FET is coupled to the second terminal of the first FET.

Optionally, the solid state switch of the first aspect further comprises a fourth FET in parallel with the second FET. Optionally, the fourth FET comprises: a first terminal; a second terminal; a bulk terminal; and, a gate terminal, and the fourth FET is configured to be switched between an on-state and an off-state. Optionally, the fourth FET is a third-type FET. Optionally, the second FET is a fourth-type FET. Optionally, the third-type is n-type or p-type. Optionally, the fourth-type is p-type or n-type. Optionally, the third-type is different to the fourth-type.

Optionally, the fourth FET is in series with the third FET. Optionally, the second terminal of the third FET is connected to the second terminal of the fourth FET.

Optionally, the output terminal of the first buffer is coupled to the bulk terminal of the third FET, and the input terminal of the first buffer is coupled to the first terminal of the third FET.

Optionally, the output terminal of the second buffer is coupled to the bulk terminal of the fourth FET, and the input terminal of the second buffer is coupled to the first terminal of the fourth FET.

Optionally, the first terminal of the third FET is a drain terminal. Optionally, the first terminal of the fourth FET is a drain terminal. Optionally, the second terminal of the third FET is a source terminal. Optionally, the second terminal of the fourth FET is a source terminal.

Optionally, the third FET is a low voltage FET, and optionally the fourth FET is a low voltage FET.

Optionally, the third FET is an isolated FET, and optionally the fourth FET is an isolated FET.

Optionally, the first FET is a JFET or a Silicon Carbide FET (SiC). Optionally, the second FET is a JFET or a SiC. Optionally, the third FET is a JFET or a SiC. Optionally, the fourth FET is a JFET or a SiC.

Optionally, the solid state switch further comprises: a fifth FET comprising a first terminal, a second terminal, a bulk terminal, and a gate terminal. Optionally, the first terminal of the fifth FET is coupled to a voltage reference, and the second terminal of the fifth FET is connected to the second terminal of the first FET. Optionally, the bulk terminal of the fifth FET is coupled to the bulk terminal of the first FET.

Optionally, the fifth FET is configured to be switched between an on-state and an off-state. Optionally, the fifth FET is configured to operate in the on-state when the first FET is in the off-state.

Optionally, the solid state switch further comprises a sixth FET comprising a first terminal, a second terminal, a bulk terminal, and a gate terminal. Optionally, the first terminal of the sixth FET is coupled to a voltage reference, and the second terminal of the sixth FET is connected to the second terminal of the second FET. Optionally, the bulk terminal of the sixth FET is coupled to the bulk terminal of the second FET.

Optionally, the sixth FET is configured to be switched between an on-state and an off-state. Optionally, the sixth FET is configured to operate in the on-state when the second FET is in the off-state.

Optionally, the voltage reference is a first voltage reference. Optionally, the solid state switch further comprises a seventh FET comprising a first terminal, a second terminal, a bulk terminal, and a gate terminal. Optionally, the first terminal of the seventh FET is coupled to a second voltage reference, and the second terminal of the seventh FET is connected to the second terminal of the third FET. Optionally the bulk terminal of the seventh FET is coupled to the bulk terminal of the third FET. Optionally, the first and second voltage references are different.

Optionally, the seventh FET is configured to be switched between an on-state and an off-state. Optionally, the seventh FET is configured to operate in the on-state when the third FET is in the off-state.

Optionally, the voltage reference is a first voltage reference. Optionally, the solid state switch further comprises an eighth FET comprising a first terminal, a second terminal, a bulk terminal, and a gate terminal. Optionally, the first terminal of the eighth FET is coupled to a second voltage reference, and the second terminal of the eighth FET is connected to the second terminal of the fourth FET. Optionally, the bulk terminal of the eighth FET is coupled to the bulk terminal of the fourth FET.

Optionally, the eighth FET is configured to be switched between an on-state and an off-state. Optionally, the eighth FET is configured to operate in the on-state when the fourth FET is in the off-state.

According to a second aspect there is provided a solid state switch, comprising:

a first field-effect transistor, FET, comprising: a first terminal, a second terminal, a bulk terminal, and a gate terminal, and configured to be switched between an on-state and an off-state;

a second FET in series with the first FET, wherein the second comprises: a first terminal, a second terminal, a bulk terminal, and a gate terminal, and wherein the second terminal of the first FET is coupled to the second terminal of the second FET;

means for providing a current source to the bulk terminal of the first FET based on the voltage at the first terminal of the first FET; and

means for providing a current source to the bulk terminal of the second FET based on the voltage at the first terminal of the second FET.

Optionally, the means for providing a current source to the bulk terminal of the first FET based on the voltage at the first terminal of the first FET is one or more first electronic components.

Optionally, means for providing a current source to the bulk terminal of the second FET based on the voltage at the first terminal of the second FET is one or more second electronic components.

Optional features of the first aspect may be applied to the second aspect.

BRIEF DESCRIPTION OF THE DRAWINGS

Figure 1a illustrates a design of an n-type MOSFET switch with its parasitic diodes D1a and D1b.

Figure 1b illustrates a source of dominant current leakage through the MOSFET switch of Figure 1a.

Figure 2 illustrates an example of a semiconductor structure of an isolated MOSFET switch, with its parasitic diodes D1a and D1b.

Figure 3 illustrates a bi-directional solid state switch with unidirectional leakage reduction comprising a first n-type MOSFET coupled in series to a second n-type MOSFET, the first MOSFET being coupled to a buffer to generate a bulk voltage substantially equal to its drain voltage.

Figure 4a illustrates a bidirectional solid state switch comprising a first n-type MOSFET coupled in series to a second n-type MOSFET, each MOSFET being coupled to a buffer to generate a bulk voltage substantially equal to its drain voltage.

Figure 4b illustrates a bidirectional solid state switch comprising a first p-type MOSFET coupled in series to a second p-type MOSFET, each MOSFET being coupled to a buffer to generate a bulk voltage substantially equal to its drain voltage.

Figure 5a illustrates a bi-directional solid state T-gate switch with bidirectional leakage reduction.

Figure 5b illustrates a bi-directional solid state T-gate switch with unidirectional leakage reduction.

Figure 5c illustrates a bi-directional solid state T-gate switch with partial leakage reduction.

Figure 6a illustrates a bi-directional solid state switch with bidirectional leakage reduction with overvoltage protection circuitry.

Figure 6b illustrates a bi-directional solid state switch with bidirectional leakage reduction with overvoltage protection circuitry.

Figure 7a illustrates a bi-directional solid state switch with unidirectional leakage reduction comprising a first n-type FET coupled in series to a second n-type FET, the first FET being coupled to a buffer to generate a bulk voltage substantially equal to its drain voltage.

Figure 7b illustrates a bi-directional solid state switch with unidirectional leakage reduction comprising a first JFET coupled in series to a second JFET, the first JFET being coupled to a buffer to generate a bulk voltage substantially equal to its drain voltage.

Figure 8 illustrates a bi-directional solid state T-gate switch with bidirectional leakage reduction.

Figure 9 illustrates a bi-directional solid state switch with bidirectional leakage reduction with overvoltage protection circuitry.

Figure 10 illustrates a bi-directional solid state switch with unidirectional leakage reduction comprising a first JFET coupled in series to a second JFET, the first JFET being coupled to a buffer to generate a bulk voltage substantially equal to its drain voltage suitable for use at high temperatures.

Figure 11 illustrates a bidirectional solid state switch with bidirectional leakage reduction suitable for use at high temperatures.

Figure 12 illustrates a bi-directional solid state T-gate switch with bidirectional leakage reduction suitable for use at high temperatures.

## DETAILED DESCRIPTION

A metal-oxide-semiconductor field-effect-transistor (MOSFET or MOS) device when configured to function as a switch is susceptible to parasitic capacitance and current leakage which can negatively impact measurement performance of equipment connected via said MOS device. To overcome the impact of parasitic capacitance and current leakage, additional circuitry can be coupled to the MOS device configured to function as a switch. Most types of field-effect-transistor devices with a designer accessible bulk terminal can benefit from the additional circuitry. For example, the devices described below are MOSFET devices configured to function as switches. A MOS device may imply a low-voltage device. For example, low voltage may be defined as: less than or equal to 5V, or, less than or equal to 10V. A low voltage MOS may be configured to operate with a *Vds* which is less than or equal to 5V, or, less than or equal to 10V.

As a brief non-limiting overview of the invention, a new MOS based switch for use in/with precision instruments is provided. The switch can enable leakage compensation. That is reduced current leakage at the input and/or output of the switch. The new MOS based switch can comprise a MOS device coupled to another MOS device in series and a respective buffer coupled to a bulk terminal of each MOS device for providing a current source to the bulk terminal of each MOS device, such that the new MOS based switch appears not to leak current from the perspective of the input and/or output terminal of the new MOS based switch. The buffer may comprise a unity gain buffer (UGB); a voltage follower; or a cascade complementary source follower.

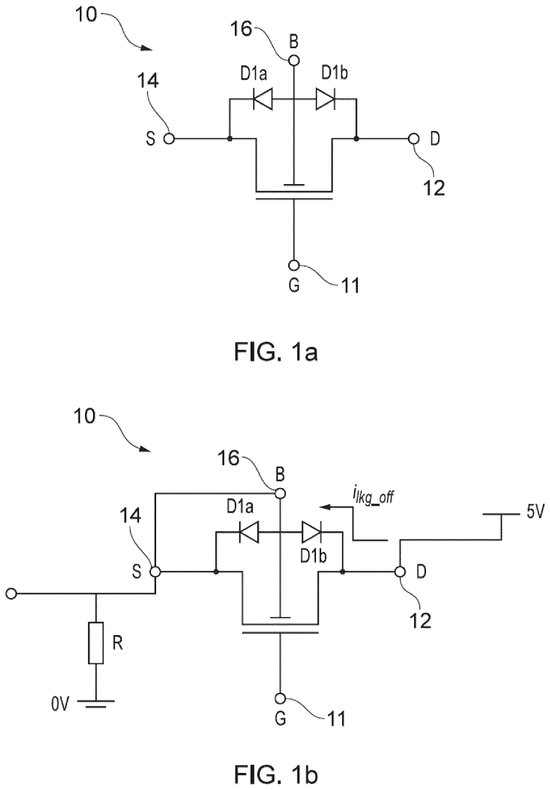

Figure 1a shows an n-type MOS 10 (i.e., NMOS 10) with its parasitic diodes D1a and D1b. The parasitic diodes D1a and D1b of the NMOS 10 result from the fabrication process and are present in the majority of types of MOS switches. The parasitic diodes D1a and D1b are formed between P-type and N-type material of the NMOS 10. The parasitic diode D1a of the NMOS 10 is formed between the p-well and a source n-type layer. The parasitic diode D1b of the NMOS 10 is formed between the drain n-type and the p-well layer. If the NMOS device was a non-isolated MOS device, then the p-well layer may be the P-type substrate layer.

NMOS 10 comprises a gate terminal 11, a drain terminal 12, a source terminal 14, and a bulk terminal 16. The bulk terminal 16 is accessible to a circuit designer. In prior-art applications, the bulk terminal is directly electrically coupled (and therefore, biased) to the source terminal to avoid body effect. A P-type MOS (PMOS) (or other p-type FET switch) could be described similarly.

Figure 1b shows the NMOS 10 of Figure 1a with a leakage current shown. When the NMOS 10 is in the on-state (i.e., switched 'ON') the drain/source voltage can be any value usually between the power supplies (e.g., *Vdd* and *Vss).* If the NMOS 10 is switched 'ON', the voltage difference between the source terminal 14 and the drain terminal 12 is approximately 0V (assuming a negligible/low ON-resistance). Typically, the bulk terminal 16 is coupled to the source terminal 14, thus, parasitic diode D1a may be ignored.

If the NMOS 10 is switched 'OFF' and the voltage at the drain 12 (e.g., 5V, or the most positive supply, e.g., *Vdd*) is greater than the voltage at the source 14 (e.g., 0V/*gnd,* or the most negative supply, e.g., *Vss),* then there is a large voltage differential across the parasitic diode D1b. The large voltage differential across the parasitic diode D1b causes a leakage current $i_{lkg\_off}$ through the reverse biased parasitic diode D1b. The leakage current $i_{lkg\text{-}off}$ reduces power efficiency and reduces the accuracy of component measurements connected via the NMOS 10. The leakage current may be defined by the Shockley diode equation:

$$i_{lkg\_off} = i_s \left( e^{\frac{V_d}{nV_t}} - 1 \right) \qquad\qquad (1)$$

where $i_s$ is the reverse-bias saturation current (or scale current), $V_d$ is the voltage across the parasitic diode D1b, $V_t$ is the thermal voltage, and n is the ideality factor (also known as the quality factor or emission coefficient) and depends on the fabrication process and semiconductor material. Therefore, if the voltage across the parasitic diode D1b is non-zero, then the leakage current $i_{lkg\_off}$ is large.

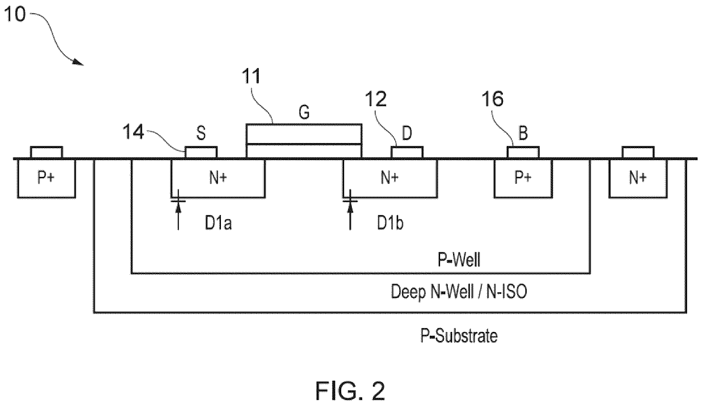

Figure 2 shows an example of a semiconductor structure of an NMOS transistor, specifically an isolated NMOS 10. The parasitic diodes D1a and D1b are shown in Figure 2. Note that the P-well is accessible to the circuit designer via the bulk terminal 16.

As shown in Figures 1a, 1b, and 2, the NMOS 10 is susceptible to leakage currents which reduce the accuracy of component measurements connected via the NMOS 10. Leakage current can also reduce the power efficiency of the NMOS 10 or components connected via the NMOS 10.

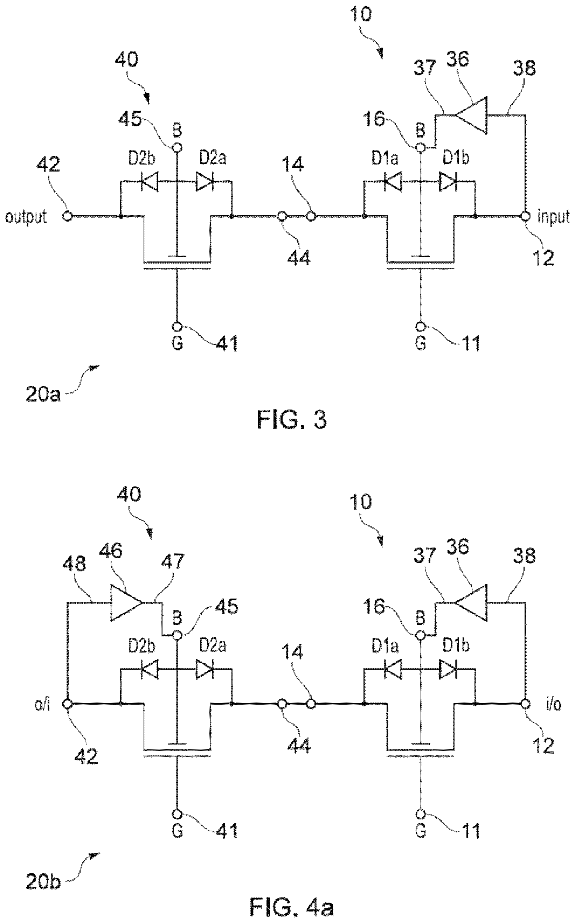

Figure 3 shows a bi-directional solid state switch 20a with unidirectional leakage reduction solid state switch 20a comprising the first NMOS 10 coupled to a first buffer 36. The first NMOS 10 being configured to be switched between an on-state (i.e., switched 'ON') and an off-state (i.e., switched 'OFF'). The first buffer 36 includes an output terminal 37; and an input terminal 38 coupled to the drain terminal 12 of the first NMOS 10. The first buffer 36 is arranged to provide a voltage to the bulk terminal 16 substantially equal to the voltage at the drain terminal 12 of the first NMOS 10. This reduces the leakage current $i_{lkg\_off}$ through parasitic diode D1b as per equation (1). The first buffer 36 connected to the first NMOS 10 may also be arranged to provide a current source to the bulk terminal 16 of the first NMOS 10 based on the voltage at the drain terminal 12 of the first NMOS 10. Thus, the addition of the first buffer 36 reduces leakage via the parasitic diode D1b when compared to an arrangement of the first NMOS 10 where the bulk terminal 16 is directly electrically coupled to the source terminal 14 (e.g., without the first buffer 36 present), or a negative voltage supply terminal (e.g., *gnd, Vss*). Therefore, the first buffer 36 may reduce (or eliminate) current leakage at the drain terminal 12 of the first NMOS 10 when the voltage at the drain terminal 12 of the first NMOS 10 is greater than the voltage at the source terminal 14 of the first NMOS 10 (e.g., by providing a 0V across the parasitic diodes D1b). However, the first buffer 36 may act as a current source and provide a large leakage current over parasitic diode D1a to the source terminal 14 of the first NMOS 10, if the voltage at the bulk terminal 16 of the first NMOS 10 is greater than the voltage at the source terminal 14 of the first NMOS 10.

To prevent the large leakage current over parasitic diode D1a to the source terminal 14 of the first NMOS 10 leaking through the solid state switch when it is in an off-state 10, a mirrored arrangement of the first NMOS 10 is provided by a second NMOS 40. The first NMOS 10 may be substantially similar to the second NMOS 40. Thus, when the voltage at the drain terminal 12 of the first NMOS 10 is greater than the voltage at the drain terminal 42 of the second NMOS 40, current leakage through the solid state switch 20a when it is in an off-state may be reduced (or eliminated). The solid state switch 20a is constructed by coupling the source terminals 14, 44 of each first NMOS 10 and second NMOS 40 together (either directly or optionally, via an electrical component for overvoltage protection). This arrangement ensures that the parasitic diode D2a (between a source terminal 44 and a bulk terminal 45 of the second NMOS 40) may be reverse biased and reduces the leakage current sourced from the first buffer 36 over the forward biased parasitic diode D1a. There may be a small current leakage via the reverse biased parasitic diode D2a (i.e., sourced from the first buffer 36), however, advantageously, this is not 'seen' at (i.e., does not interact with) the drain terminal of the first NMOS 10. Thus, from the perspective of the input terminal 12 of the solid state switch 20a, current leakage may be eliminated.

Specifically, Figure 3 shows the solid state switch 20a comprises the second NMOS 40. The second NMOS 40 being configured to be switched between an on-state and an off-state. Figure 3 shows the second NMOS 40 with parasitic diodes D2a and D2b. The second NMOS 40 comprises a gate terminal 41, a drain terminal 42, a source terminal 44, and a bulk terminal 45. The bulk terminal 45 is accessible to a circuit designer.

An input of the solid state switch 20a may be the drain terminal 12 of the first NMOS 10. An output of the solid state switch 20a may be the drain terminal 42 of the second NMOS 40.

A switching signal coupled to the gate 41 of the second NMOS 40 may also be coupled to the gate 11 of the first NMOS 10, such that the first and second NMOSs 10, 40 are configured to be in the same switching state, either 'ON' or 'OFF'. Thus, during an off-state of the solid state switch 20, the first and second MOSs 10 and 40 can be switched 'OFF' simultaneously. Similarly, during an on-state of the solid state switch 20, the first and second MOSs 10 and 40 can be switched 'ON' simultaneously.

In an off-state, the bulk terminal 45 if second NMOS 40 may be coupled to the most negative supply of the switch (e.g., 0V, *gnd,* or *Vss).* In an on-state, the bulk terminal 45 of second NMOS 40 may also be coupled to the most negative supply of the switch (e.g., 0V, *gnd,* or *Vss*). Alternatively, in an on-state, the bulk terminal 45 of second NMOS 40 may be back gate switched. In back gate switching, the bulk terminal (e.g., 45) is tied to the signal passing through the switch (e.g., second NMOS 40) to reduce the body effect and improve performance.

The solid state switch 20a of Figure 3 may be particularly advantageous when used in a multiplexed system.

Figure 4a shows a bi-directional solid state switch 20b with bi-directional leakage reduction comprising the solid state switch 20a of Figure 3, and a second buffer 46. That is, the arrangement of the second NMOS 40 and the second buffer 46a is a mirrored arrangement of the first NMOS 10 and the first buffer 36. The first buffer 36 may be substantially similar to the second buffer 46. The second buffer 46 may include an output terminal 47, and an input terminal 48 coupled to the drain terminal 42 of the second NMOS 40.

Considering a scenario whereby the solid state switch 20b is arranged such that the voltage at the drain terminal 42 of the second NMOS 40 is greater than the voltage at the drain terminal 12 of the first NMOS 10. The second buffer 46 which is connected to the second NMOS 40 may be arranged to provide a voltage to the bulk terminal 45 substantially equal to the voltage at the drain terminal 42 of the second NMOS 40. This reduces the leakage current $i_{lkg\_off}$ through parasitic diode D2b as per equation (1). The second buffer 46 connected to the second NMOS 40 may also be arranged to provide a current source to the bulk terminal 45 of the second NMOS 40 based on the voltage at the drain terminal 42 of the second NMOS 40. Thus, the addition of the second buffer 46 reduces leakage via the parasitic diode D2b when compared to an arrangement of the solid state switch 20 where the bulk terminal 45 is directly electrically coupled to the source terminal 44 (e.g., without the second buffer 46 present). Therefore, the second buffer 46 may reduce (or eliminate) leakage at the drain terminal 42 of the second NMOS 40 when the voltage at the drain terminal 42 of the second NMOS 10 is greater than the voltage at the source terminal 44 of the second NMOS 40 (e.g., by providing a 0V across the parasitic diodes D2b).

Advantageously, the buffers 36, 46 of bi-directional solid state switch 20b may reduce (or eliminate) leakage if there is any voltage differential between the drain terminal 42 of the second NMOS 40 and the drain terminal 12 of the first NMOS 10.

In addition, the parasitic diode D1a (between a source terminal 14 and a bulk terminal 16 of the first NMOS 10) may be reverse biased and reduces the leakage current sourced from the second buffer 46 over the forward biased parasitic diode D2a. Thus, from the perspective of the input/output terminals of the solid state switch 20b, leakage may be eliminated, and the accuracy of component measurements connected via the solid state switch 20b can be improved.

Optionally, the first and/or second buffer 36, 46 is a unitary gain buffer (UGB) (e.g., an operational amplifier-based buffer circuit with unitary gain). The first and second UGB 36, 46 provides a low impedance output and therefore can source or sink current at the output terminal 37, 47 of the first and second UGB 36, 46, respectively. Therefore, current leakage from parasitic diodes D1b and D2b can (in theory) be eliminated, or at least greatly reduced. Therefore, an advantage of a UGB 36, 46 is that leakage may be reduced at the drain terminal of the first and second NMOS 10, 40. A reduced leakage can result in improved power efficiency and accuracy of component measurements connected via the solid state switch (e.g., solid state switch 20a, 20b, etc.). In addition, one or more UGBs 36, 46 can beneficially provide a particularly low voltage difference between the input terminal 38, 48 voltage and output terminal 37, 47. Therefore, the UGB 36, 46 can achieve improved accuracy of component current measurements due to low current leakage at the input and/or output of the solid state switch 20a, 20b. Additionally, if one or more buffers (such as first and second buffers 36, 46, and optionally, gate drive circuitry configured to operate the gates of the first NMOS 10 and the second NMOS 40 each) comprise an operational amplifier, then improved THD can be achieved.

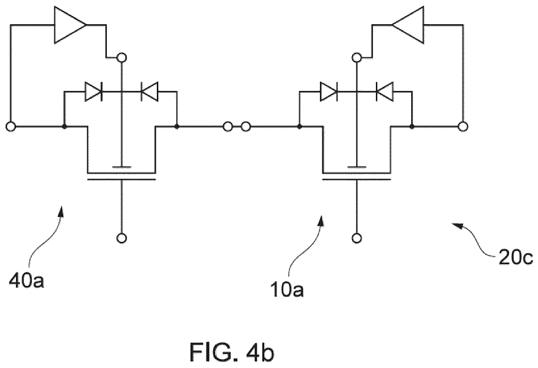

Figure 4b shows a solid state switch 20c which may operate substantially similarly to the solid state switch 20b of Figure 4a. The solid state switch 20c comprises PMOS devices 10a, 40a in place of the NMOS devices 10, 40. Specifically, a first terminal (e.g., a source terminal) of a first PMOS 10a is coupled to a first terminal (e.g., a source terminal) of a second PMOS 40a.

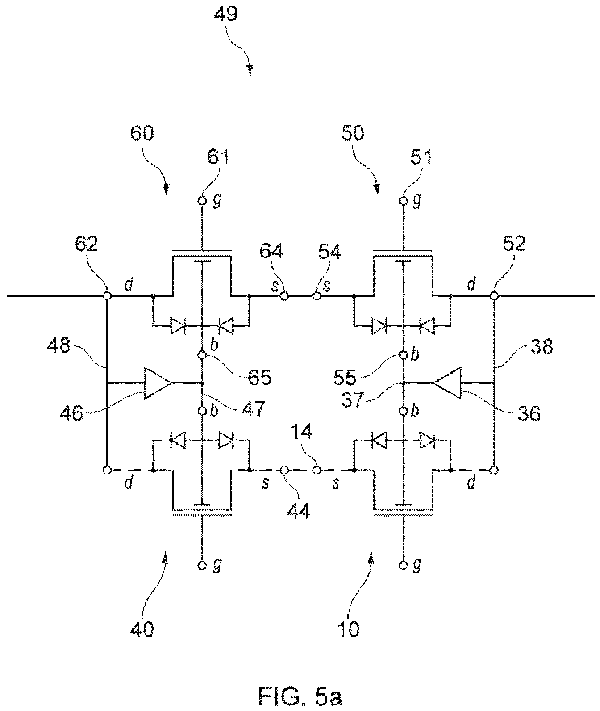

Figure 5a shows a bi-directional solid state switch 49 whereby the arrangement of the first and second MOSFETs 10, 40, and the first and second buffers 36, 46 corresponds with the arrangement as shown in Figure 4a. Advantageously, Figure 5a provides bidirectional leakage reduction. In addition, Figure 5a comprises a third and a fourth MOSFETs 50, 60. The third MOSFET 50 is in series with the fourth MOSFET 60. The third MOSFET 50 comprises: a gate terminal 51, a drain terminal 52, a source terminal 54 and a bulk terminal 65. The fourth MOSFET 60 comprises: a gate terminal 61, a drain terminal 62, a source terminal 64 and a bulk terminal 65. The output terminal 37 of the first buffer 36 is coupled to the bulk terminal 55 of the third MOSFET 50, and the input terminal 38 of the first buffer 36 is coupled to the drain terminal 52 of the third MOSFET 50. The output terminal 47 of the second buffer 46 is coupled to the bulk terminal 65 of the fourth MOSFET 60, and the input terminal 48 of the second buffer 46 is coupled to the drain terminal 62 of the fourth MOSFET 60. The third MOSFET may be a first PMOS 50 and the fourth MOSFET 60 may be a second PMOS 60.

The solid state switch 49 of Figure 5a is a bi-directional solid state transmission-gate (i.e., T-gate) switch 49. The bi-directional solid state T-gate switch 49 comprises an n-type bi-directional solid state switch comprising first and second NMOS 10, 40 in parallel with a p-type bi-directional solid state switch comprising first and second PMOS 50, 60. Advantageously, the bi-directional solid state T-gate switch 49 provides full rail-to-rail signal pass.

Alternatively, the solid state T-gate switch 49 may be arranged to only reduce (or eliminate) leakage from only one of the two input/output terminals of the solid state switch 49, (similar to the solid state switch 20a of Figure 3) by removing the second buffer 46 (or by removing the first buffer 36) from the solid state T-gate switch 49 shown at Figure 5a.

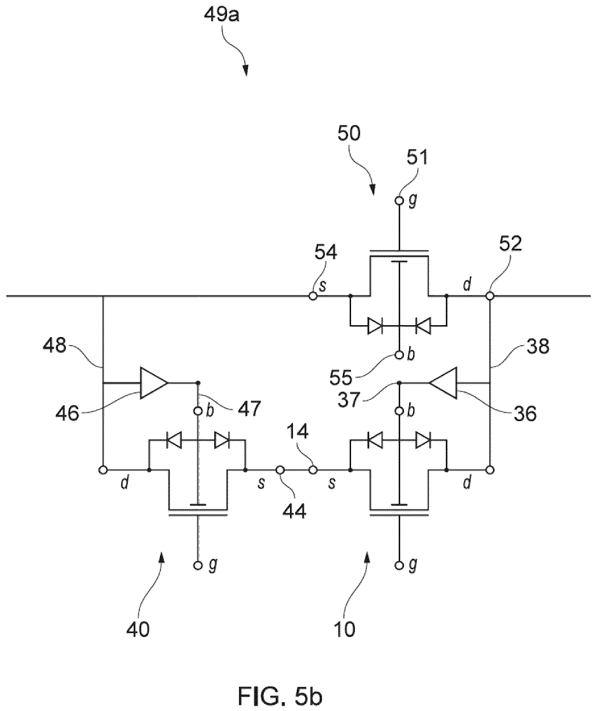

Alternatively, a solid state switch may be substantially similar to the bi-directional solid state T-gate switch 49 of Figure 5a but may only comprise one of either the first or second PMOS 50, 60 and therefore, not provide leakage compensation to the remaining PMOS, for example, see Figure 5b. Alternatively or in addition, a solid state switch may be substantially similar to the bi-directional solid state T-gate switch 49 of Figure 5a but may only comprise one of either the first or second NMOS 10, 40. For a first example, the bi-directional solid state T-gate switch 49 of Figure 5a may be modified such that any one of the MOSFETs 10, 40, 50, or 60 of the bi-directional solid state T-gate switch 49 are absent. If one of the MOSFETs 10, 40, 50, 60 are absent then the resulting open-circuited source terminal (e.g., either 14, 44, 54, 64) may be coupled to:

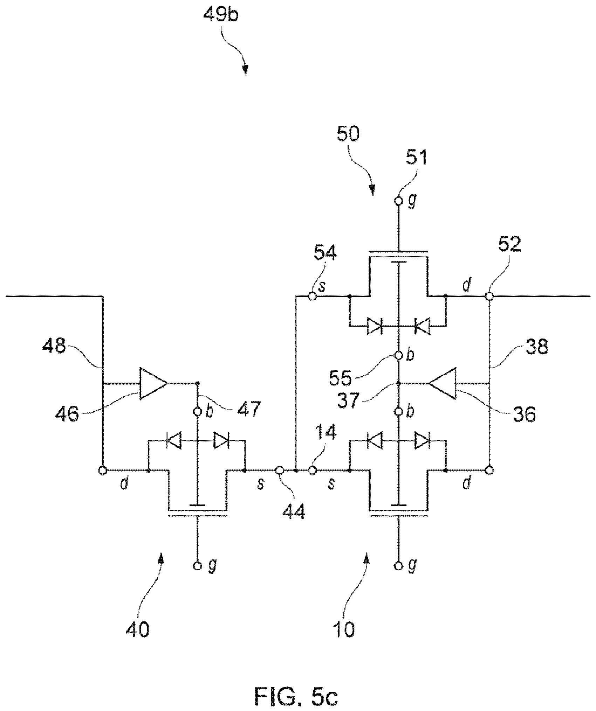

a) one or more of the remaining source terminals of the remaining MOSFETs (i.e., any three of MOSFETs 10, 40, 50, 60), as shown by Figure 5c; or
b) coupled to the input or output terminal 52, 62 of the solid state switch (e.g., such that the all remaining three MOSFETs pass current between the input and the output terminals 52, 62 of the solid state switch when the solid state switch is turned "ON"), as shown by Figure 5b.

In example a), shown by Figure 5c, the gate drive signal of the second MOSFET 40 is greater than the gate drive signal of the remaining MOSFETs 10, 50. For example, the gate drive signal of the second MOSFET 40 may be Vth (i.e., "ON" threshold voltage) above the gate drive signals of the remaining MOSFETs 10, 50.

For a second example, the bi-directional solid state T-gate switch 49 of Figure 5a may be modified such that any two of the MOSFETs 10, 40, 50, or 60 are absent. In the second example, it is preferable (in order to maintain bi-directional functionality) that either: first PMOS 50 and second PMOS 60 are absent (i.e., corresponding to solid state switch 20 of Figure 4a); first NMOS 10 and second NMOS 40 are absent (i.e., corresponding to solid state switch 20a of Figure 4b); first NMOS 10 and second PMOS 60 are absent (and the source terminal 54 of the first PMOS 50 is coupled to the source terminal 44 of the second NMOS 40); or, first PMOS 50 and second NMOS 40 are absent (and the source terminal 14 of the first NMOS 10 is coupled to the source terminal 64 of the second PMOS 60).

The T-gate arrangement described with reference to Figure 5a comprises two buffers 36, 46. Alternatively, the bi-directional solid state T-gate switch 49 with may be reconfigured to use a buffer associated with the bulk terminal of each MOSFET.

Alternatively, the MOSFETs of Figures 5a-6b may be any type of MOSFETs respectively.

In an example, the solid state switches as shown in Figures 3, 4a, 4b, 5a, 5b, or 5c may further comprise an electrical component for overvoltage protection. The electrical component may be arranged in series between the first and second MOSFETs (e.g., NMOSs 10 and 40 of Figure 3, 4a, 4b, 5a, 5b, and 5c). The electrical component may protect the solid state switch in applications where overvoltage conditions can cause damage to a device to which the switch is connected. That is, the solid state switch may have overvoltage protection characteristics.

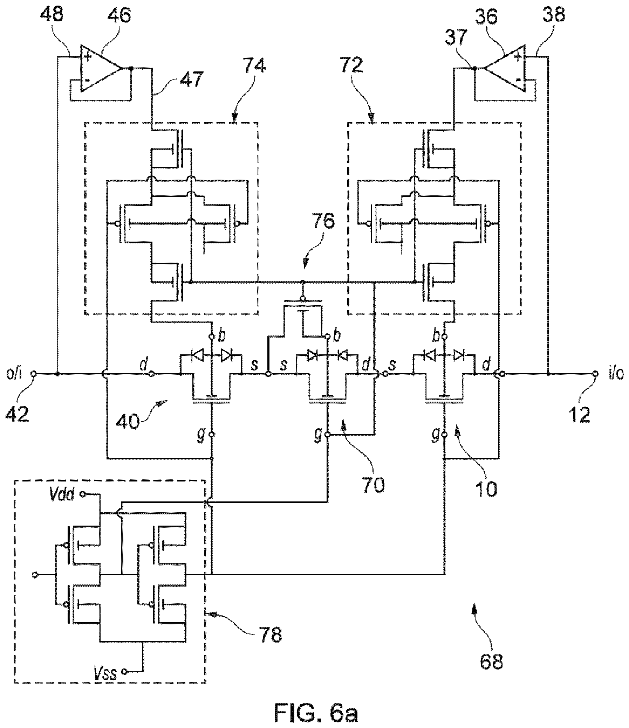

Figure 6a shows a bi-directional solid state switch 68 with an overvoltage MOSFET 70 (for overvoltage protection) arranged in series between the first and second MOSFETs 10, 40. Although, in practice all three MOSFETs (i.e., first and second MOSFETs 10, 40, and overvoltage MOSFET 70) provide overvoltage protection, specifically, NMOS devices provide overvoltage protection for positive voltages and PMOS devices provide overvoltage protection for negative voltages. Advantageously, Figure 6a provides bidirectional leakage reduction, due to the presence of two buffers 36, 46. The overvoltage MOSFET is of a different type to the first and second MOSFETs 10, 40. The bi-directional solid state switch 68 includes three series-connected MOS transistors: first NMOS 10, a PMOS 70 and second NMOS 40. The first and third MOSFETs 10, 40 are shown as N-type MOSFETs and the middle MOSFET 70 is shown as a P-type MOSFET in Figure 6a. Alternatively, the first and third MOSFETs 10, 40 may be P-type MOSFETs and the middle MOSFET 76 may be a N-type MOSFET. Alternatively, all three MOSFETs may be of the same type, for example, this may be advantageous in examples if the expected input/output overvoltages were different. For the architecture of Figure 6a, it is the voltage rating of the MOSFETs that set the overvoltage protection level.

The bi-directional solid state switch 68 of Figure 6a may provide positive and negative overvoltage protection (e.g., +55V, and -45V) when the bi-directional solid state switch 68 is powered via *Vdd* and *Vss,* and when the solid state switch is unpowered (i.e., the power supplies *Vdd ~ = Vss ~ = gnd).*

The switch input/output terminal 12 of the bi-directional solid state switch 68 is the drain terminal 12 of the first NMOS transistor 10. The bulk terminal of the first NMOS 10 is coupled to the output terminal 37 of the first buffer 36 via a first protection circuit 72. The drain terminal of the PMOS 70 is coupled to the source electrode of the first NMOS 10. The source terminal of the PMOS 70 is coupled to the source electrode of the second NMOS 40. The switch input/output terminal 42 of the solid state switch is the drain terminal of the second NMOS transistor 40. The bulk terminal of the second NMOS 40 is coupled to the output terminal 47 of the second buffer 46 via a second protection circuit 74. The bulk terminal of the PMOS 70 may be configured to float when the solid state switch is turned 'OFF'. Specifically, a bulk-source PMOS 76 with a gate terminal coupled to the gate terminal of the PMOS 70 may be arranged to cause the bulk terminal of the PMOS 70 to float when it is in an off-state. When the bi-directional solid state switch 68 is in an off-state, the bulk terminals of the first NMOS 10 and second NMOS 40 are coupled to output terminals 37, 47 of the first and second buffers 36, 46 respectively. Thus, reducing (or eliminating) current leakage at the inputs/outputs 12, 42 of the bi-directional solid state switch 68. Alternatively, the bulk-source PMOS 76 of Figure 6a may be replaced with a bulk-drain PMOS 76 (i.e., between the bulk terminal and the drain terminal of the PMOS 70).

The bulk terminal of the PMOS 70 may be configured to be coupled to the source terminal of the PMOS 70 when the bi-directional solid state switch 68 is turned 'ON', such that the PMOS 70 does not impede the signal through the bi-directional solid state switch 68. Specifically, the bulk-source PMOS 76 with a gate terminal coupled to the gate terminal of the PMOS 70 may be arranged to cause the bulk terminal of the PMOS 70 to be coupled to the source terminal of the PMOS 70 when it is in an on-state. When the bi-directional solid state switch 68 is in an on-state, the bulk terminals of the first NMOS 10 and second NMOS 40 may be configured to float, for example, due to the first and second protection circuits 72, 74.

The gate terminals of the NMOSs 10, 40 are coupled together and to a first output of a control circuit 78. The gate terminal of the PMOS 70 is coupled to a second output of the control circuit 78, such that the PMOS 70, first NMOS 10, and second NMOS 40 may be in the on-state (or off-state) at the same time (e.g., switched simultaneously).

In the example described, control signals output from the first output and second output of the control circuit 78 respectively are either +15 volts or -15 volts (alternatively, these may +5V or -5V), derived from the supply voltages. The control signals are complementary, such that when one is +15 volts, the other is -15 volts. When the first control signal is +15 volts, the first and second NMOSs 10, 40 are turned on. The second control signal will at that time be -15 volts, and this voltage on the gate terminal 32 of the PMOS 70 (and bulk-source PMOS 76) will turn PMOS 70 on. Thus, all three in-series MOSFETs (i.e., first NMOS 10, PMOS 70, and second NMOS 40) are turned 'ON', and the switch is "closed", meaning that an input signal can be transmitted from the input to the output of the bi-directional solid state switch 68.

When the second control signal is +15 volts and the first control signal is -15 volts, all three MOSFETs (i.e., first NMOS 10, PMOS 70, and second NMOS 40) will be turned 'OFF', and bi-directional solid state switch 68 will open, that is, its resistance from the input terminal 12 to the output terminal 42 will be extremely high (typically megohms), effectively preventing signal transmission through the bi-directional solid state switch 68.

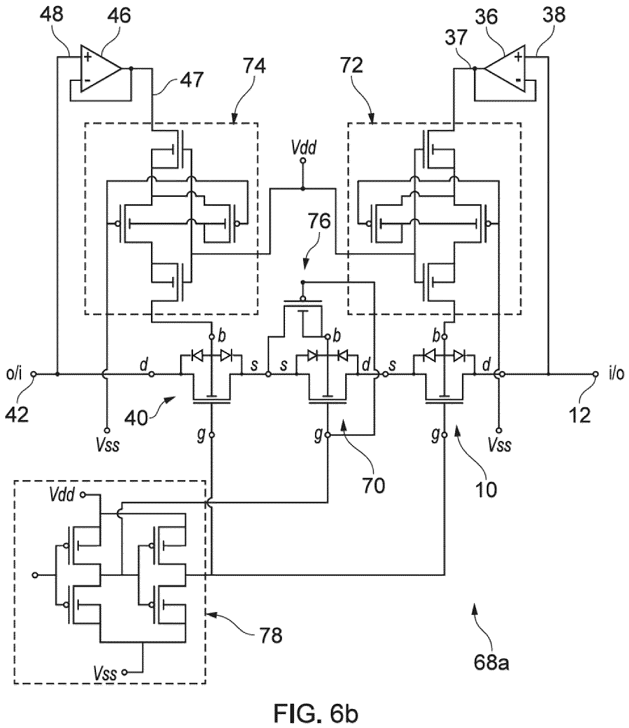

Figure 6b, shows an alternative bi-directional solid state switch 68a with an overvoltage MOSFET 70 (for overvoltage protection) arranged in series between the first and second MOSFETs 10, 40. The bi-directional solid state switch 68a shows all of the components of the bi-directional solid state switch 68 of Figure 6a. The same reference numerals are used to denote the same/corresponding features in relation to Figure 6a and will not be described in detail again below. Specifically, in contrast to the bi-directional solid state switch 68 of Figure 6a, the first and second protection circuits 72, 74 may be configured to be always 'ON' by tying the gates of NMOS devices to *Vdd* and the gates of PMOS devices to *Vss,* as shown in Figure 6b. This will always drive the bulk terminals of all three MOSFETs (i.e., first NMOS 10, PMOS 70, and second NMOS 40) with the buffer 36, 46 except in an overvoltage event when the bulk terminals will be automatically floated. Advantageously, this provides better performance in the 'ON' state of the bi-directional solid state switch 68a.

Each MOSFET of the solid state switch 20a, 20b, 20c, 49, 68 may be a low voltage MOSFET. Low voltage may be defined as: less than or equal to 5V, or, less than or equal to 10V. A low voltage MOS may be configured operate with a *Vds* which is less than or equal to 5V, or, less than or equal to 10V. Low voltage components and MOSFET devices may advantageously provide reduced area and power consumption in comparison to higher voltage components.

The values of any components herein may be changed depending on the application and/or designer choice.

For all of the above designs and circuits, it is possible to add additional components while still achieving the technical effects associated with each embodiment.

Alternatively, the MOS devices herein may comprise an isolation terminal or may not comprise an isolation terminal (e.g. Silicon on Insulator (SOI) devices). The output terminal of the first buffer 36 may only be coupled to the bulk terminal of the first MOSFET 10 when the first MOSFET 10 is in the off-state. The output terminal of the second buffer 46 may only be coupled to the bulk terminal of the second MOSFET 40 when the second MOSFET 40 is in the off-state.

The first and second MOSFET devices 10, 40 of Figures 3-6b are shown as n-type devices, however, the teachings can be readily applied to p-type devices by a person skilled in the art, and vice versa.

The output terminals 37 of the first and second buffers 36, 46 are shown to be coupled to the bulk terminals of both the first MOSFET 10 and the second MOSFET 40 in Figures 3-6b. Alternatively, any means for providing a current source to the bulk terminal of the first MOSFET 10 based on the voltage at the drain terminal 12 of the first MOSFET 10 may be used in order to achieve reduced leakage, and/or any means for providing a current source to the bulk terminal of the second MOSFET 40 based on the voltage at the drain terminal 42 of the second MOSFET 40 may be used in order to achieve reduced leakage. For example, if the second MOSFET 40 has different leakage characteristics to the first MOSFET 10. The above applies equally to the other MOSFETs in a similar arrangement, e.g., the third and Fourth MOSFETs 50, 60 of Figures 5a-5c, and/or PMOS 70 of Figures 6a, 6b.

The MOSFETs herein (e.g., 10, 40, 50, 60, 70) may be any type of MOSFET design.

When reference is made to a drain, source, gate, bulk, buried layer, isolation layer or other input/output of a component, this may include a drain terminal, source terminal, gate terminal, bulk terminal, buried layer terminal, isolation terminal or other input/output terminal of a component, respectively (and vice versa).

Throughout the described embodiments, where a MOSFET has a 'drain terminal', this may be referred to as a 'first terminal', and where a MOSFET has a 'source terminal', this may be referred to as a 'second terminal'. This is due to the symmetrical nature of certain MOSFETs as a result of their fabrication method. Additionally, it will be understood that due to the symmetrical nature of MOSFETs, in any embodiment described herein, the orientation of the first and second terminals of each MOSFET may be arbitrary. For example, Figure 4a may show the first terminal of the first MOSFET 10 coupled in series to the second terminal of the second MOSFET 40, and the input terminals of the first and second buffers 36, 46 may be coupled to the second terminal of the first MOSFET 10 and the first terminal of the second MOSFET 40 respectively.

The first and/or second buffer 36, 46 may each be a unity gain buffer in Figures 3 to 6b. The unity gain buffer may comprise an operational amplifier to reduce leakage and capacitance at the drain of the connected MOS (e.g., the first MOSFET 10 in Figures 3 to 6b). The operational amplifier may be one of: a continuous time auto-zero operational amplifier; or a continuous time ping-pong auto zero operational amplifier, to achieve a low voltage difference across the input terminal 38, 48 and the output terminal 37, 47 of the first and/or second buffer 36, 46.

Alternatively, the first and/or second buffer 36, 46 may each be a voltage follower circuit. The voltage follower circuit can reduce capacitance at the drain of the connected MOSFET (e.g., the first MOSFET 10 in Figures 3 to 6b). The voltage follower circuit is simpler to implement and reduces circuit complexity. The voltage follower circuit is usually an open loop or feedforward type circuit.

Alternatively, the first and/or second buffer 36, 46 may each be a cascade complementary source follower (CCSF). The CCSF can reduce capacitance at the drain of the connected MOSFET (e.g., the first MOSFET 10 in Figures 3 to 6b). The CCSF is simpler to implement and reduces circuit complexity. The CCSF can achieve near zero voltage drop across the CCSF, although, this may vary with temperature and silicon processes. Alternatively, the first and/or second buffer 36, 46 may each be any other implementation of a source follower type circuit or buffer.

The first and/or second buffer 36, 46 may each be any means for providing a current source to the bulk terminal of a MOSFET (e.g., MOSFET 10, and/or MOSFET 40 respectively) based on the voltage at the first terminal (e.g., the drain terminal) of the MOSFET.

In an example, the NMOS devices 10, 40, 50, 60 and/or the PMOS devices 10a, 20a, 70 may be a non-isolated MOS devices. Alternatively, the NMOS devices 10, 10a, 40, 40a, 50, 60, 70 may be an isolated MOS devices.

In addition to MOS devices described above, other Field Effect Transistor (FET) devices may be used in place of the MOS devices described with reference to Figures 1 to 6b. A FET device may be configured to function as a switch and is susceptible to parasitic capacitance and current leakage which can negatively impact measurement performance of equipment connected via said FET device. To overcome the impact of parasitic capacitance and current leakage, additional circuitry can be coupled to the FET device configured to function as a switch. FET devices (e.g., JFET, Silicon Carbide FET (SiC), and MOS devices, etc.) which comprise at least one parasitic diodes D1a and D1b (as shown with reference to Figures 1a and 1b) can benefit from the additional circuitry described with reference to Figures 1 to 6b. Examples of other FET devices with additional circuitry corresponding to certain examples shown in Figures 1 to 6b are described below.

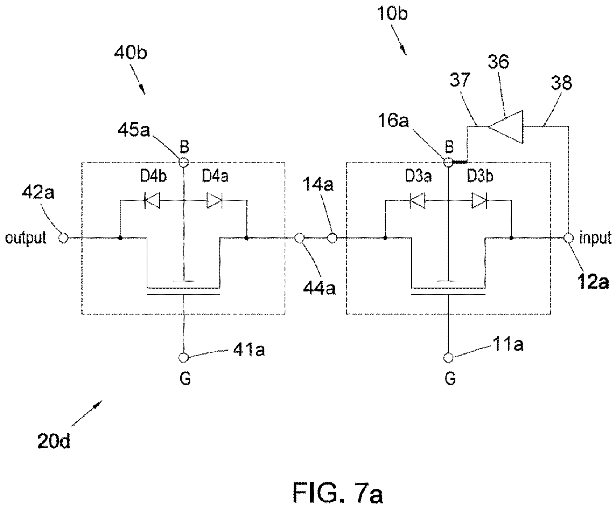

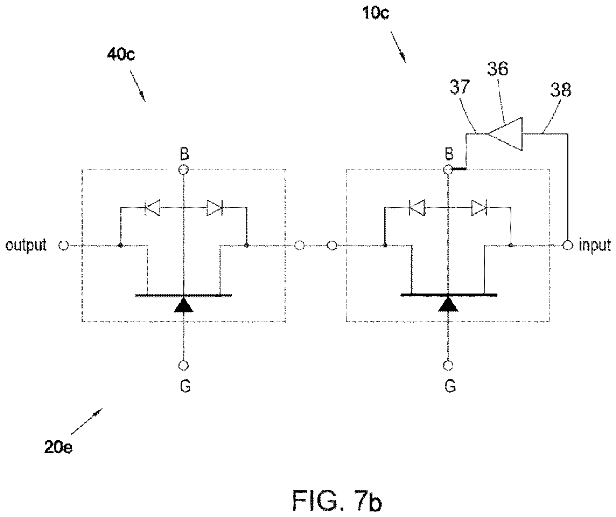

Figures 7a and 7b show bi-directional solid state switches 20d, 20e with unidirectional leakage reduction. Some of the components in Figures 7a and 7b are similar to components in FIG. 3 and use the same reference numbers. For purposes of conciseness, similar components will not be described in detail again. In contrast to the solid state switch device 20a of Figure 3, solid state switch device 20d, 20e of Figures 7a and 7b show a first and second FET 10b, 10c, 40b, 40c as an alternative to the first and second NMOS 10, 40.

In the example of Figure 7a, the first and second FETs are first and second SiCs 10b, 40b (e.g., in a MOSFET form as show, or JFET form (not shown)). In the example of Figure 7b, the first and second FETs are first and second JFETs 10c, 40c. The bulk terminal (also called a back gate terminal) of a JFET may also be the gate terminal of a JFET. In another example, the first and second FETs may be any other type of FET.

In an example, the first and second FETs may be first and second SiCs as will be described below. Figure 7a shows the bi-directional solid state switch 20d with unidirectional leakage reduction comprising the first SiC 10b coupled to a first buffer 36. The first SiC 10b being configured to be switched between an on-state (i.e., switched 'ON') and an off-state (i.e., switched 'OFF'). The first buffer 36 includes an input terminal 38 coupled to the drain terminal 12a of the first SiC 10b. The first buffer 36 is arranged to provide a voltage to the bulk terminal 16a substantially equal to the voltage at the drain terminal 12a of the first SiC 10b. This reduces the leakage current $i_{lkg\_off}$ through parasitic diode D3b. The first buffer 36 connected to the first SiC 10b may also be arranged to provide a current source to the bulk terminal 16a of the first SiC 10b based on the voltage at the drain terminal 12a of the first SiC 10b.

A mirrored arrangement of the first SiC 10b is provided by a second SiC 40b. The first SiC 10b may be substantially similar to the second SiC 40b. Thus, when the voltage at the drain terminal 12a of the first SiC 10b is greater than the voltage at the drain terminal 42a of the second SiC 40b, current leakage through the solid state switch 20d when it is in an off-state may be reduced (or eliminated). The solid state switch 20d is constructed by coupling the source terminals 14a, 44a of each first SiC 10b and second SiC 40b together (either directly or optionally, via an electrical component for overvoltage protection). This arrangement ensures that the parasitic diode D4a (between a source terminal 44a and a bulk terminal 45a of the second SiC 40b) may be reverse biased and reduces the leakage current sourced from the first buffer 36 over the forward biased parasitic diode D3a. There may be a small current leakage via the reverse biased parasitic diode D4a (i.e., sourced from the first buffer 36), however, advantageously, this is not 'seen' at (i.e., does not interact with) the drain terminal of the first SiC 10b. Thus, from the perspective of the input terminal 12a of the solid state switch 20d, current leakage may be eliminated.

Specifically, Figure 7a shows the solid state switch 20d comprises the second SiC 40b. The second SiC 40b being configured to be switched between an on-state and an off-state. Figure 7a shows the second SiC 40b with parasitic diodes D4a and D4b. The second SiC 40b comprises a gate terminal 41a, a drain terminal 42a, a source terminal 44a, and a bulk terminal 45a. The bulk terminal 45a is accessible to a circuit designer.

An input of the solid state switch 20d may be the drain terminal 12a of the first SiC 10b. An output of the solid state switch 20d may be the drain terminal 42a of the second SiC 40b.

A switching signal coupled to the gate 41a of the second SiC 40b may also be coupled to the gate 11a of the first SiC 10b, such that the first and second SiCs 10b, 40b are configured to be in the same switching state, either 'ON' or 'OFF'. Thus, during an off-state of the solid state switch 20d, the first and second SiCs 10b and 40b can be switched 'OFF' simultaneously. Similarly, during an on-state of the solid state switch 20d, the first and second SiCs 10b and 40b can be switched 'ON' simultaneously.

In an off-state, the bulk terminal 45a of second SiC 40b may be coupled to the most negative supply of the switch (e.g., 0V, *gnd,* or *Vss).* In an on-state, the bulk terminal 45a of second SiC 40b may also be coupled to the most negative supply of the switch (e.g., 0V, *gnd,* or *Vss*). Alternatively, in an on-state, the bulk terminal 45a of second SiC 40b may be back gate switched. In back gate switching, the bulk terminal (e.g., 45b) is tied to the signal passing through the switch (e.g., second SiC 40b) to reduce the body effect and improve performance.

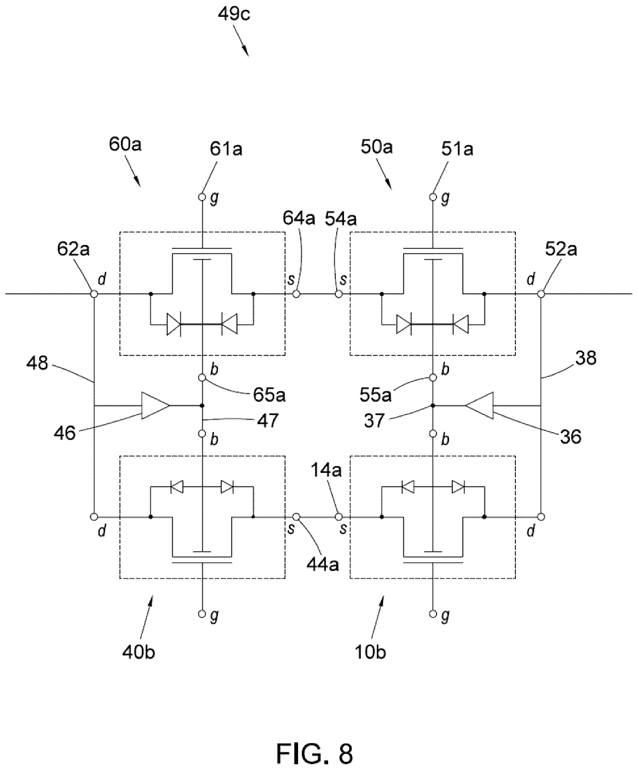

Figure 8 shows a bi-directional solid state switch 49c with bi-directional leakage reduction. Some of the components in FIG. 8 are similar to components in FIG. 5a and use the same reference numbers. For purposes of conciseness, similar components will not be described in detail again. In contrast to the solid state switch device 49 of Figure 5a, solid state switch device 49c of Figure 8 shows a first, second, third, and fourth FET 10b, 40b, 50a, 60a as an alternative to the first, second, third, and fourth MOSFETs 10, 40, 50, 60.

In an example, the first, second, third, and fourth FETs 10b, 40b, 50a, 60a may be first, second, third, and fourth SiCs, JFETs, other type of FETs, or combinations thereof.

In an example, the first, second, third, and fourth FETs 10b, 40b, 50a, 60a may be first, second, third, and fourth SiCs as will be described below. Figure 8 shows a bi-directional solid state switch 49c. Advantageously, the example of Figure 8 provides bidirectional leakage reduction. In addition, Figure 8 comprises a third SiC 50a and a fourth SiC 60a. The third SiC 50a is in series with the fourth SiC 60a. The third SiC 50a comprises: a gate terminal 51a, a drain terminal 52a, a source terminal 54a and a bulk terminal 65a. The fourth SiC 60a comprises: a gate terminal 61a, a drain terminal 62a, a source terminal 64a and a bulk terminal 65a. The output terminal 37 of the first buffer 36 is coupled to the bulk terminal 55a of the third SiC 50a, and the input terminal 38 of the first buffer 36 is coupled to the drain terminal 52a of the third SiC 50a. The output terminal 47 of the second buffer 46 is coupled to the bulk terminal 65a of the fourth SiC 60a, and the input terminal 48 of the second buffer 46 is coupled to the drain terminal 62a of the fourth SiC 60a. The third SiC 50a may be p-type and the fourth SiC 60a may be p-type.

The solid state switch 49c of Figure 8 is a bi-directional solid state transmission-gate (i.e., T-gate) switch 49c. The bi-directional solid state T-gate switch 49c comprises an n-type bi-directional solid state switch comprising first and second n-type SiCs 10b, 40b in parallel with a p-type bi-directional solid state switch comprising first and second p-type SiCs 50a, 60a. Advantageously, the bi-directional solid state T-gate switch 49c provides full rail-to-rail signal pass.

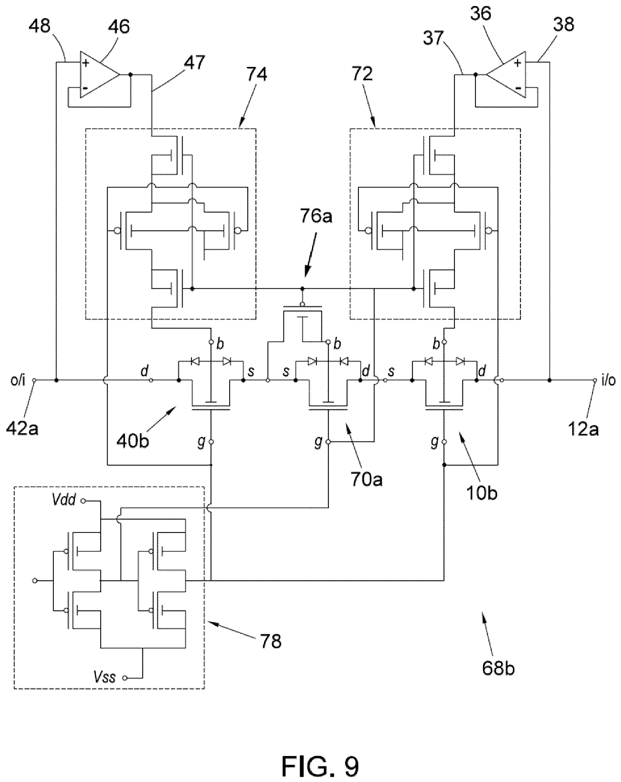

Figure 9 shows a bi-directional solid state switch 68b with an overvoltage FET 70a (for overvoltage protection) arranged in series between the first and second FETs 10b, 40b. Some of the components in Figure 9 are similar to components in Figure 6a and use the same reference numbers. For purposes of conciseness, similar components will not be described in detail again. In contrast to the solid state switch device 68 of Figure 6a, solid state switch device 68b of Figure 9 shows a first, second, and overvoltage FET 10b, 40b, 70a as an alternative to the first, second, and overvoltage MOSFETs 10, 40, 70. The overvoltage FET 70a is of a different type to the first and second FETs 10b, 40b.

In an example, the first, second, and overvoltage FETs 10b, 40b, 70a may be first, second, and overvoltage JFETs, SiCs, or other type of FET.

In an example, the first, second, and overvoltage FETs 10b, 40b, 70a may be first, second, and overvoltage SiCs as will be described below. Figure 9 provides bidirectional leakage reduction, due to the presence of two buffers 36, 46. The overvoltage SiC 70a is of a different type to the first and second SiCs 10b, 40b. The bi-directional solid state switch 68b includes three series-connected SiC transistors: first n-type SiC 10b, an overvoltage p-type SiC 70a and second n-type SiC 40b. The first and third SiCs 10b, 40b are shown as n-type SiCs and the middle SiC 70a is shown as a p-type SiC in Figure 9.

Alternatively, the first and third SiCs 10b, 40b may be p-type SiCs and the middle SiC 70a may be a n-type SiC.

Alternatively, all three SiCs may be of the same type, for example, this may be advantageous in examples if the expected input/output overvoltages were different. For the architecture of Figure 9, it is the voltage rating of the FETs that set the overvoltage protection level.

The bi-directional solid state switch 68b of Figure 9 may provide positive and negative overvoltage protection (e.g., +55V, and -45V) when the bi-directional solid state switch 68b is powered via *Vdd* and *Vss,* and when the solid state switch is unpowered (i.e., the power supplies *Vdd ~ = Vss ~ = gnd*).

The switch input/output terminal 12a of the bi-directional solid state switch 68b is the drain terminal 12a of the first SiC transistor 10b. The bulk terminal of the first SiC 10b is coupled to the output terminal 37 of the first buffer 36 via a first protection circuit 72. The drain terminal of the overvoltage SiC 70s is coupled to the source electrode of the first SiC 10b. The source terminal of the overvoltage SiC 70a is coupled to the source electrode of the second SiC 40b. The switch input/output terminal 42a of the solid state switch is the drain terminal of the second SiC transistor 40b. The bulk terminal of the second SiC 40b is coupled to the output terminal 47 of the second buffer 46 via a second protection circuit 74. The bulk terminal of the overvoltage SiC 70a may be configured to float when the solid state switch is turned 'OFF'. Specifically, a bulk-source SiC 76a with a gate terminal coupled to the gate terminal of the overvoltage SiC 70a may be arranged to cause the bulk terminal of the overvoltage SiC 70a to float when it is in an off-state. When the bi-directional solid state switch 68b is in an off-state, the bulk terminals of the first SiC 10b and second SiC 40b are coupled to output terminals 37, 47 of the first and second buffers 36, 46 respectively. Alternatively, the bulk-source SiC 76a of Figure 9 may be replaced with a bulk-drain SiC (i.e., between the bulk terminal and the drain terminal of the overvoltage SiC 70a). In an example, the bulk-source SiC (or the bulk-drain SiC) may be any FET.

The gate terminals of the SiCs 10b, 40b are coupled together and to a first output of a control circuit 78. The gate terminal of the overvoltage SiC 70a is coupled to a second output of the control circuit 78, such that the overvoltage SiC 70a, first SiC 10b, and second SiC 40b may be in the on-state (or off-state) at the same time (e.g., switched simultaneously).

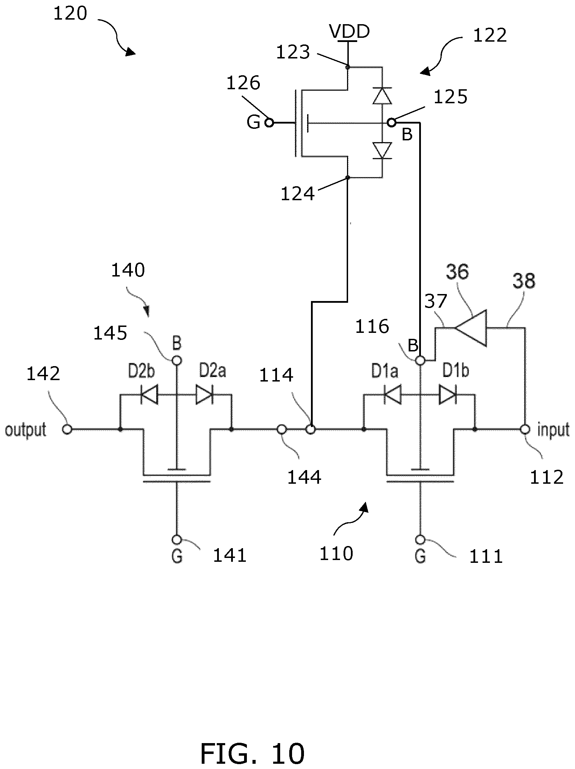

In examples, any of the circuits described with reference to Figures 3 to 9, may be provided with additional components to provide temperature resilience as described with reference to Figures 10 to 12. Specifically, at temperatures greater than 85°C, 100°C, or 125°C, the additional components described with reference to Figures 10 to 12 may further reduce current leakage.

Figure 10 shows a bi-directional solid state switch 120 with unidirectional leakage reduction which may correspond with any of bi-directional solid state switches 20a 20d, 20e. Some of the components in Figures 10 are the same/similar to components in Figures 3, 7a, and 7b (and may use the same reference numbers), for example a first FET 110 of Figure 10 corresponds to any of the first FET 10, 10b, 10c, and a second FET 140 of Figure 10 corresponds to any of the second FET 40, 40b, 40c. For purposes of conciseness, same/similar components will not be described in detail again. In contrast to the solid state switch devices 20a, 20d, 20e of Figures 3, 7a, and 7b, solid state switch device 120 of Figure 10 comprises an additional FET 122 (herein labelled "fifth FET 122" in order to provide a unique label for the purposes of clarity) to the solid state switch 120.

The solid state switch device 120 of Figure 10 is suitable for use at high temperatures (e.g., temperatures greater than 85°C, 100°C, or 125°C,). For example, at high temperatures, the solid state switch 120 may reduce current leakage when the first and second FETs 110, 140 are in their off-state and the input 12 of the solid state switch 120 is at a greater voltage potential than the output 42 of the solid state switch 120.

In the example of Figure 10, each of the first, second, and/or fifth FETs 110, 140, 122 may be any type of FET, e.g., a MOSFET, a SiC FET, a JFET, etc.

The fifth FET 122 comprises a first terminal 123, a second terminal 124, a bulk terminal 125, and a gate terminal 126. The first terminal 123 of the fifth FET 122 is coupled to a voltage reference (e.g., VDD if the fifth FET 122 is a n-type FET, or VSS if the fifth FET 122 is a p-type FET), and the second terminal 124 of the fifth FET 122 is connected to the second terminal 114 of the first FET 110. The bulk terminal 125 of the fifth FET 122 may be coupled to the bulk terminal 116 of the first FET 110. In an alternative example, the bulk terminal 125 of the fifth FET 122 may be coupled to a voltage source which approximates the voltage at the bulk terminal 116 of the first FET 110.

The fifth FET 122 is configured to be switched between an on-state and an off-state. The fifth FET 122 is configured to operate in the on-state when the first FET is in the off-state.

In an example, a first gate control signal for the first and second FETs 110, 140 may be inverted with respect to a second gate control signal for the fifth FET 122. For example, the first gate control signal may be coupled to the gate terminal 111, 141 of the first and second FETs 110, 140, and an input of an inverter circuit (e.g., comprising, or consisting of, a NOT gate). The output of the inverter circuit may be coupled to the gate terminal 126 of the fifth FET 122. The inverter circuit may operate similarly to the control circuit 78.

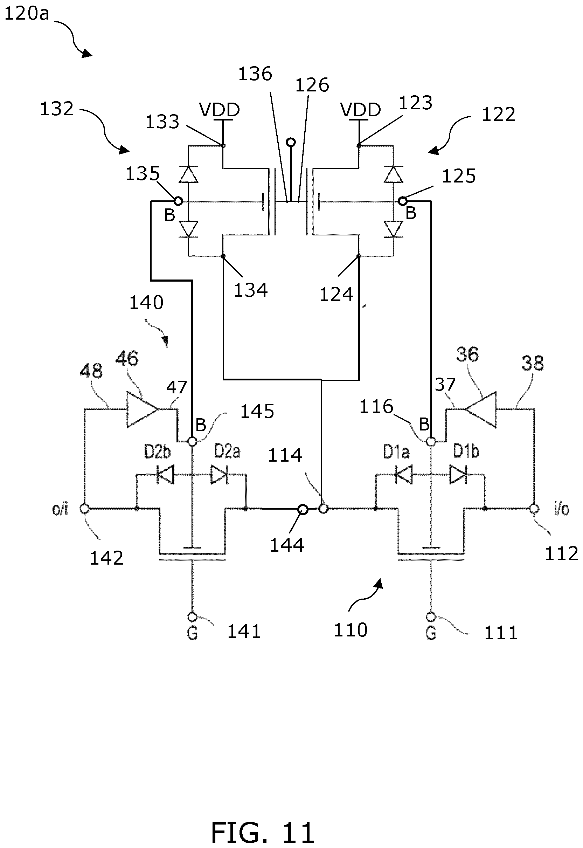

Figure 11 shows a bi-directional solid state switch 120a with bi-directional leakage reduction which may correspond with any of bi-directional solid state switches 20b 20c. The arrangement of the second FET 140 and the second buffer 46 is a mirrored arrangement of the first FET 110 and the first buffer 36. The first buffer 36 may be substantially similar to the second buffer 46. Some of the components in Figures 11 are the same/similar to components in Figures 4a and 10 (and may use the same reference numbers). For purposes of conciseness, same/similar components will not be described in detail again. In contrast to the solid state switch devices 20b, 20c of Figures 4a and 4b, solid state switch device 120a of Figure 11 comprises a second additional FET 132 (herein labelled "sixth FET 132" in order to provide a unique label for the purposes of clarity) to the solid state switch 120a.

The solid state switch device 120a of Figure 11 is suitable for use at high temperatures (e.g, temperatures greater than 85°C, 100°C, or 125°C,). For example, at high temperatures the solid state switch 120a may reduce current leakage when the first and second FETs 110, 140 are in their off-state.

In the example of Figure 11, each of the first, second, fifth, and/or sixth FETs 110, 140, 122, 132 may be any type of FET, e.g., a MOSFET, a SiC FET, a JFET, etc.

The sixth FET 132 comprises a first terminal 133, a second terminal 134, a bulk terminal 135, and a gate terminal 136. The first terminal 133 of the sixth FET 132 is coupled to a voltage reference (e.g., VDD), and the second terminal 134 of the sixth FET 132 is connected to the second terminal 144 of the second FET 140. The bulk terminal 135 of the sixth FET 132 may be coupled to the bulk terminal 145 of the second FET 140. In an alternative example, the bulk terminal 135 of the sixth FET 132 may be coupled to a voltage source which approximates the voltage at the bulk terminal 145 of the second FET 140.

In the example of Figure 11, the sixth FET 132 is arranged in parallel with the fifth FET 122. The voltage reference (e.g., VDD) is coupled to the first terminal 133 of the sixth FET 132 and the first terminal of the fifth FET 122. The gate terminal 136 of the sixth FET 132 is coupled to the gate terminal 126 of the fifth FET 122.

The sixth FET 132 is configured to be switched between an on-state and an off-state. The sixth FET 132 is configured to operate in the on-state when the second FET 140 is in the off-state.

In an example, a first gate control signal for the first and second FETs 110, 140 may be inverted with respect to a second gate control signal for the fifth and sixth FETs 122, 132. For example, the first gate control signal may be coupled to the gate terminal 111, 141 of the first and second FETs 110, 140, and an input of an inverter circuit (e.g., comprising, or consisting of, a NOT gate). The output of the inverter circuit may be coupled to the gate terminal 126 of the fifth FET 122, and the gate terminal 136 of the sixth FET 132. The inverter circuit may operate similarly to the control circuit 78.

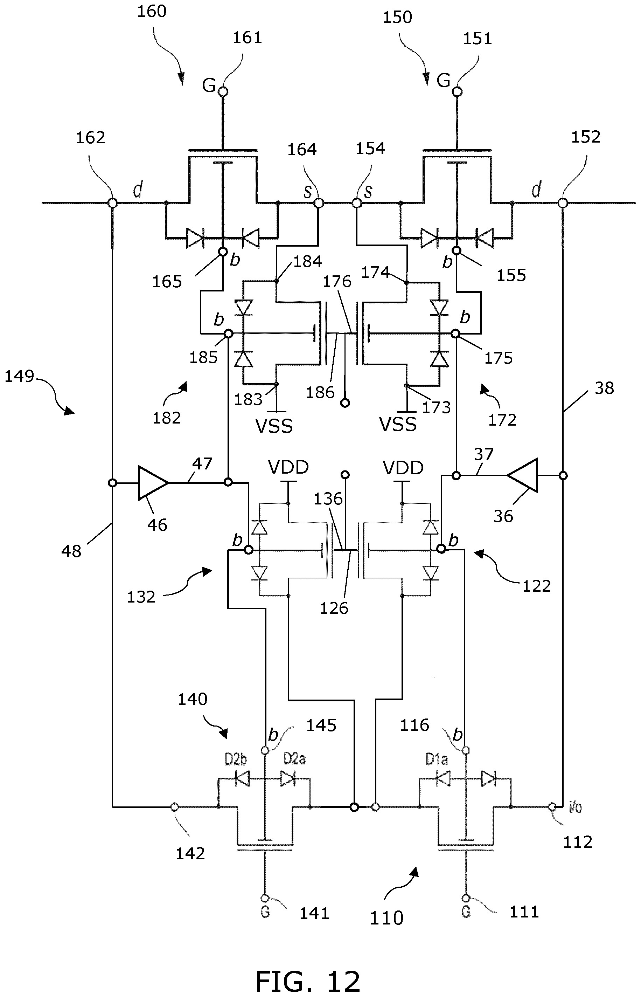

Figure 12 shows a bi-directional solid state switch 149 with bi-directional leakage reduction which may correspond with any of bi-directional solid state switches 49, 49c. Some of the components in FIG. 12 are the same/similar to components in Figures 5a, 8, and 11 (and may use the same reference numbers). For example, a third FET 150 of Figure 12 may correspond to any of the third FET 50, 50a of Figures 5a and 8, and a fourth FET 140 of Figure 12 may correspond to any of the fourth FET 60, 60a of Figures 5a and 8. For purposes of conciseness, similar components will not be described in detail again. In contrast to the solid state switch device 49, 49c of Figures 5a and 8, solid state switch device 149 of Figure 12 comprises a third additional FET 172 (herein labelled "seventh FET 172" in order to provide a unique label for the purposes of clarity) and a fourth additional FET 182 (herein labelled "eighth FET 182" in order to provide a unique label for the purposes of clarity) to the solid state switch 149.

Figure 12 illustrates a bi-directional solid state T-gate switch with bidirectional leakage reduction suitable for use at high temperatures (e.g., temperatures greater than 85°C, 100°C, or 125°C,). For example, at high temperatures the solid state switch 149 may reduce current leakage when the first, second, third and fourth FETs 110, 140, 150, 160 are in their off-state.

In the example of Figure 12, each of the first, second, third, fourth, fifth, sixth, seventh, and/or eighth FETs 110, 140, 150, 160, 122, 132, 172, 182 may be any type of FET, e.g., a MOSFET, a SiC FET, a JFET, etc.

The seventh FET 172 comprises a first terminal 173, a second terminal 174, a bulk terminal 175, and a gate terminal 176. The first terminal 173 of the seventh FET 172 is coupled to a second voltage reference (e.g., VSS), and the second terminal 174 of the seventh FET 172 is coupled to the second terminal 154 of the third FET 150. The bulk terminal 175 of the seventh FET 172 may be coupled to the bulk terminal 155 of the third FET 150. In an alternative example, the bulk terminal 175 of the seventh FET 172 may be coupled to a voltage source which approximates the voltage at the bulk terminal 155 of the third FET 150.

The eighth FET 182 comprises a first terminal 183, a second terminal 184, a bulk terminal 185, and a gate terminal 186. The first terminal 183 of the eighth FET 182 is coupled to a second voltage reference (e.g., VSS), and the second terminal 184 of the eighth FET 182 is connected to the second terminal 164 of the fourth FET 160. The bulk terminal 185 of the eighth FET 182 may be coupled to the bulk terminal 165 of the fourth FET 160. In an alternative example, the bulk terminal 185 of the eighth FET 182 may be coupled to a voltage source which approximates the voltage at the bulk terminal 165 of the fourth FET 160.

In the example of Figure 12, the seventh FET 172 is arranged in parallel with the eighth FET 182. The second voltage reference (e.g., VSS) is coupled to the first terminal 173 of the seventh FET 172 and the first terminal 183 of the eighth FET 182. The gate terminal 176 of the seventh FET 172 is coupled to the gate terminal 186 of the eighth FET 182.

The seventh FET 172 is configured to be switched between an on-state and an off-state. The seventh FET 172 is configured to operate in the on-state when the third FET 150 is in the off-state. The eighth FET 182 is configured to be switched between an on-state and an off-state. The eighth FET 182 is configured to operate in the on-state when the fourth FET 160 is in the off-state.

In an example, a first gate control signal for the first, second, seventh, and eighth FETs 110, 140, 172, 182 may be inverted with respect to a second gate control signal for the third, fourth, fifth, and sixth, seventh, and eighth FETs 150, 160, 122, 132. For example, the first gate control signal may be coupled to the gate terminal 111, 141, 176, 186 of the first, second, seventh, and eighth FETs 110, 140, 172, 182, and an input of an inverter circuit (e.g., comprising, or consisting of, a NOT gate). The output of the inverter circuit may be coupled to the gate terminals 151, 161, 126, 136, 176, 186 of the third, fourth, fifth, and sixth, FETs 150, 160, 122, 132. The inverter circuit may operate similarly to the control circuit 78.

The solid state switch 149 of Figure 12 is a bi-directional solid state transmission-gate (i.e., T-gate) switch 149. The bi-directional solid state T-gate switch 149 comprises an n-type bi-directional solid state switch comprising n-type first, second, fifth, and sixth FETs 110, 140, 122, 132 in parallel with a p-type bi-directional solid state switch comprising p-type third, fourth, seventh, and eighth FETs 150, 160, 172, 182. Advantageously, the bi-directional solid state T-gate switch 149 provides full rail-to-rail signal pass.

In an alternative example, the solid state T-gate switch 149 may be arranged to only reduce (or eliminate) leakage from only one of the two input/output terminals of the solid state switch 149, (similar to the solid state switch 120 of Figure 10) by removing the second buffer 46 (or by removing the first buffer 36) from the solid state T-gate switch 149 shown at Figure 12.

In an alternative example, a solid state switch may be substantially similar to the bi-directional solid state T-gate switch 149 of Figure 12 but may only comprise either: the third and seventh FETs 150, 172; or the fourth and eighth FETs 160, 182. Therefore, the resulting solid state switch may not provide leakage compensation to the remaining p-type FETs, similar to the examples of Figures 5b and/or 5c.

In an example of Figures 10 to 12, each of the fifth FET 122, the sixth FET 132, the seventh FET 172, and/or the eighth FET 182 may be a low voltage FET. In an example of Figures 10 to 12, each of the fifth FET 122, the sixth FET 132, the seventh FET 172, and/or the eighth FET 182 may be an isolated FET.

In an example of Figures 10 to 12, the first terminal 123 of the fifth FET 122 is a drain terminal, and the second terminal 124 of the fifth FET 122 is a source terminal. In an example of Figures 10 to 12, the first terminal 133 of the sixth FET 132 is a drain terminal, and the second terminal 134 of the sixth FET 132 is a source terminal. In an example of Figures 10 to 12, the first terminal 173 of the seventh FET 172 is a drain terminal, and the second terminal 174 of the seventh FET 172 is a source terminal. In an example of Figures 10 to 12, the first terminal 183 of the eighth FET 182 is a drain terminal, and the second terminal 184 of the eighth FET 182 is a source terminal.

General

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to."

The words "coupled" or "connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list. Moreover, in the following claims, the terms "first", "second", "third", "fourth", etc. are used merely as labels, and are not intended to impose numerical requirements on their objects.

It is to be understood that one or more features from one or more of the above- described embodiments may be combined with one or more features of one or more other ones of the above-described embodiments, so as to form further embodiments which are within the scope of the appended claims.

NUMBERED CLAUSES

Numbered clause 1. A solid state switch, comprising:

a first metal-oxide-semiconductor field-effect transistor, MOSFET, comprising: a first terminal, a second terminal, a bulk terminal and a gate terminal, and configured to be switched between an on-state and an off-state;
a second MOSFET in series with the first MOSFET, wherein the second MOSFET comprises a first terminal, a second terminal, a bulk terminal, and a gate terminal, and wherein the second terminal of the first MOSFET is connected to the second terminal of the second MOSFET; and,
a first buffer comprising an output terminal coupled to the bulk terminal of the first MOSFET, and an input terminal coupled to the first terminal of the first MOSFET.

Numbered clause 2. The solid state switch of numbered clause 1, wherein the first buffer is: a unity gain buffer, UGB; a voltage follower; or a cascade complementary source follower.

Numbered clause 3. The solid state switch of numbered clause 1 or 2, further comprising a second buffer comprising an output terminal coupled to the bulk terminal of the second MOSFET, and an input terminal coupled to the first terminal of the second MOSFET.

Numbered clause 4. The solid state switch of numbered clause 3, wherein the second buffer is: a unity gain buffer, UGB; a voltage follower; or a cascade complementary source follower.

Numbered clause 5. The solid state switch of any previous numbered clause, wherein the first buffer is a UGB so as to reduce leakage at the first terminal of the first MOSFET.

Numbered clause 6. The solid state switch of any previous numbered clause, wherein the first MOSFET is a low voltage MOSFET, and the second MOSFET is a low voltage MOSFET.

Numbered clause 7. The solid state switch of any previous numbered clause, wherein the first MOSFET is an isolated MOSFET, and the second MOSFET is an isolated MOSFET.

Numbered clause 8. The solid states switch of any previous numbered clause, wherein the first terminal of the first MOSFET is a drain terminal, wherein the first terminal of the second MOSFET is a drain terminal, wherein the second terminal of the first MOSFET is a source terminal, wherein the second terminal of the second MOSFET is a source terminal.

Numbered clause 9. The solid state switch of any preceding numbered clause, wherein the first and second MOSFET are both a first-type MOSFET, wherein the first-type is n-type or p-type.

Numbered clause 10. The solid state switch of numbered clause 9, further comprising an electrical component for overvoltage protection, wherein the electrical component is arranged in series between the first and second MOSFETs.

Numbered clause 11. The solid state switch of numbered clause 10, wherein the electrical component is a third MOSFET, wherein the third MOSFET is a second-type MOSFET, wherein the second-type is p-type or n-type, wherein the first-type is different to the second-type.

Numbered clause 12. The solid state switch of numbered clauses 10 or 11, wherein the electrical component protects the solid state switch in applications where overvoltage conditions can cause damage to a device to which the switch is connected.

Numbered clause 13. The solid state switch of any of numbered clauses 1 to 9, wherein the solid state switch is a transmission-gate switch comprising the first MOSFET in parallel with a third MOSFET, wherein the third MOSFET, comprises: a first terminal; a second terminal; a bulk terminal; and, a gate terminal, and the third MOSFET is configured to be switched between an on-state and an off-state, wherein the third MOSFET is a first-type MOSFET, wherein the first MOSFET is a second-type MOSFET, wherein the first-type is n-type or p-type, wherein the second-type is p-type or n-type, wherein the first-type is different to the second-type.

Numbered clause 14. The solid state switch of numbered clause 13, wherein the solid state switch further comprises a fourth MOSFET in parallel with the second MOSFET, wherein the fourth MOSFET comprises: a first terminal; a second terminal; a bulk terminal; and, a gate terminal, and the fourth MOSFET is configured to be switched between an on-state and an off-state, wherein the fourth MOSFET is a third-type MOSFET, wherein the second MOSFET is a fourth-type MOSFET, wherein the third-type is n-type or p-type, wherein the fourth-type is p-type or n-type, wherein the third-type is different to the fourth-type.

Numbered clause 15. The solid state switch of numbered clause 14, wherein the fourth MOSFET is in series with the third MOSFET, and wherein the second terminal of the third MOSFET is connected to the second terminal of the fourth MOSFET.

Numbered clause 16. The solid state switch of numbered clause 15, wherein the output terminal of the first buffer is coupled to the bulk terminal of the third MOSFET, and the input terminal of the first buffer is coupled to the first terminal of the third MOSFET; and/or when dependent on numbered clause 3, wherein the output terminal of the second buffer is coupled to the bulk terminal of the fourth MOSFET, and the input terminal of the second buffer is coupled to the first terminal of the fourth MOSFET.

Numbered clause 17. The solid states switch of numbered clause 16, wherein the first terminal of the third MOSFET is a drain terminal, wherein the first terminal of the fourth MOSFET is a drain terminal, wherein the second terminal of the third MOSFET is a source terminal, wherein the second terminal of the fourth MOSFET is a source terminal.

Numbered clause 18. The solid state switch of any of numbered clauses 13 to 17, wherein the third MOSFET is a low voltage MOSFET, and the fourth MOSFET is a low voltage MOSFET.

Numbered clause 19. The solid state switch of any of numbered clauses 13 to 18, wherein the third MOSFET is an isolated MOSFET, and the fourth MOSFET is an isolated MOSFET.

Numbered clause 20. A solid state switch, comprising:

a first metal-oxide-semiconductor field-effect transistor, MOSFET, comprising: a first terminal, a second terminal, a bulk terminal, and a gate terminal, and configured to be switched between an on-state and an off-state;
a second MOSFET in series with the first MOSFET, wherein the second comprises: a first terminal, a second terminal,

a bulk terminal, and a gate terminal, and wherein the second terminal of the first MOSFET is coupled to the second terminal of the second MOSFET;
means for providing a current source to the bulk terminal of the first MOSFET based on the voltage at the first terminal of the first MOSFET; and means for providing a current source to the bulk terminal of the second MOSFET based on the voltage at the first terminal of the second MOSFET.

Numbered clause 21. A solid state switch, comprising:

a first field-effect transistor, FET, comprising: a first terminal, a second terminal, a bulk terminal and a gate terminal, and configured to be switched between an on-state and an off-state;
a second FET in series with the first FET, wherein the second FET comprises a first terminal, a second terminal, a bulk terminal, and a gate terminal, and wherein the second terminal of the first FET is connected to the second terminal of the second FET; and,
a first buffer comprising an output terminal coupled to the bulk terminal of the first FET, and an input terminal coupled to the first terminal of the first FET.

Numbered clause 22. The solid state switch of numbered clause 21, wherein the first buffer is: a unity gain buffer, UGB; a voltage follower; or a cascade complementary source follower.

Numbered clause 23. The solid state switch of numbered clause 21 or 22, further comprising a second buffer comprising an output terminal coupled to the bulk terminal of the second FET, and an input terminal coupled to the first terminal of the second FET.

Numbered clause 24. The solid state switch of numbered clause 23, wherein the second buffer is: a unity gain buffer, UGB; a voltage follower; or a cascade complementary source follower.

Numbered clause 25. The solid state switch of any of numbered clauses 21 to 24, wherein the first buffer is a UGB so as to reduce leakage at the first terminal of the first FET.

Numbered clause 26. The solid state switch of any of numbered clauses 21 to 25, wherein the first FET is a low voltage FET, and the second FET is a low voltage FET.

Numbered clause 27. The solid state switch of any of numbered clauses 21 to 26, wherein the first FET is an isolated FET, and the second FET is an isolated FET.

Numbered clause 28. The solid states switch of any of numbered clauses 21 to 27, wherein the first terminal of the first FET is a drain terminal, wherein the first terminal of the second FET is a drain terminal, wherein the second terminal of the first FET is a source terminal, wherein the second terminal of the second FET is a source terminal.

Numbered clause 29. The solid state switch of any of numbered clauses 21 to 28, wherein the first and second FET are both a first-type FET, wherein the first-type is n-type or p-type.

Numbered clause 30. The solid state switch of numbered clause 29, further comprising an electrical component for overvoltage protection, wherein the electrical component is arranged in series between the first and second FETs.

Numbered clause 31. The solid state switch of numbered clause 30, wherein the electrical component is a third FET, wherein the third FET is a second-type FET, wherein the second-type is p-type or n-type, wherein the first-type is different to the second-type.

Numbered clause 32. The solid state switch of any of numbered clauses 30 or 31, wherein the electrical component protects the solid state switch in applications where overvoltage conditions can cause damage to a device to which the switch is connected.

Numbered clause 33. The solid state switch of any of numbered clauses 21 to 29, wherein the solid state switch is a transmission-gate switch comprising the first FET in parallel with a third FET, wherein the third FET, comprises: a first terminal; a second terminal; a bulk terminal; and, a gate terminal, and the third FET is configured to be switched between an on-state and an off-state, wherein the third FET is a first-type FET, wherein the first FET is a second-type FET, wherein the first-type is n-type or p-type, wherein the second-type is p-type or n-type, wherein the first-type is different to the second-type.

Numbered clause 34. The solid state switch of numbered clause 33, wherein the solid state switch further comprises a fourth FET in parallel with the second FET, wherein the fourth FET comprises: a first terminal; a second terminal; a bulk terminal; and, a gate terminal, and the fourth FET is configured to be switched between an on-state and an off-state, wherein the fourth FET is a third-type FET, wherein the second FET is a fourth-type FET, wherein the third-type is n-type or p-type, wherein the fourth-type is p-type or n-type, wherein the third-type is different to the fourth-type.

Numbered clause 35. The solid state switch of numbered clause 34, wherein the fourth FET is in series with the third FET, and wherein the second terminal of the third FET is connected to the second terminal of the fourth FET.

Numbered clause 36. The solid state switch of numbered clause 35, wherein the output terminal of the first buffer is coupled to the bulk terminal of the third FET, and the input terminal of the first buffer is coupled to the first terminal of the third FET, and/or when dependent on numbered clause 23, wherein the output terminal of the second buffer is coupled to the bulk terminal of the fourth FET, and the input terminal of the second buffer is coupled to the first terminal of the fourth FET.

Numbered clause 37. The solid states switch of numbered clause 36, wherein the first terminal of the third FET is a drain terminal, wherein the first terminal of the fourth FET is a drain terminal, wherein the second terminal of the third FET is a source terminal, wherein the second terminal of the fourth FET is a source terminal.

Numbered clause 38. The solid state switch of any of numbered clauses 33 to 37, wherein the third FET is a low voltage FET, and the fourth FET is a low voltage FET.

Numbered clause 39. The solid state switch of any of numbered clauses 33 to 38, wherein the third FET is an isolated FET, and the fourth FET is an isolated FET.

Numbered clause 40. The solid state switch of any of numbered clauses 21 to 39, wherein the first FET is a JFET or a Silicon Carbide FET (SiC); and/or wherein the second FET is a JFET or a SiC.

Numbered clause 41. A solid state switch, comprising:

a first field-effect transistor, FET, comprising: a first terminal, a second terminal, a bulk terminal, and a gate terminal, and configured to be switched between an on-state and an off-state;
a second FET in series with the first FET, wherein the second comprises: a first terminal, a second terminal, a bulk terminal, and a gate terminal, and wherein the second terminal of the first FET is coupled to the second terminal of the second FET;
means for providing a current source to the bulk terminal of the first FET based on the voltage at the first terminal of the first FET; and
means for providing a current source to the bulk terminal of the second FET based on the voltage at the first terminal of the second FET.

Numbered clause 42. A solid state switch, comprising:

a first field-effect transistor, FET, comprising: a first terminal, a second terminal, a bulk terminal and a gate terminal, and configured to be switched between an on-state and an off-state;
a second FET in series with the first FET, wherein the second FET comprises a first terminal, a second terminal, a bulk terminal, and a gate terminal, and wherein the second terminal of the first FET is connected to the second terminal of the second FET; and,
a first buffer comprising an output terminal coupled to the bulk terminal of the first FET, and an input terminal coupled to the first terminal of the first FET.

Numbered clause 43. The solid state switch of numbered clause 42, further comprising: a fifth FET comprising a first terminal, a second terminal, a bulk terminal, and a gate terminal, and wherein the first terminal of the fifth FET is coupled to a voltage reference, and the second terminal of the fifth FET is connected to the second terminal of the first FET, and optionally the bulk terminal of the fifth FET is coupled to the bulk terminal of the first FET.

Numbered clause 44. The solid state switch of numbered clause 43, wherein the fifth FET is configured to be switched between an on-state and an off-state, wherein the fifth FET is configured to operate in the on-state when the first FET is in the off-state.

Numbered clause 45. The solid state switch of any of numbered clauses 42 to 44, further comprising a second buffer comprising an output terminal coupled to the bulk terminal of the second FET, and an input terminal coupled to the first terminal of the second FET.

Numbered clause 46. The solid state witch of any of numbered clauses 42 to 45, further comprising: a sixth FET comprising a first terminal, a second terminal, a bulk terminal, and a gate terminal, and wherein the first terminal of the sixth FET is coupled to a voltage reference, and the second terminal of the sixth FET is connected to the second terminal of the second FET, and optionally the bulk terminal of the sixth FET is coupled to the bulk terminal of the second FET.

Numbered clause 47. The solid state switch of numbered clause 46, wherein the sixth FET is configured to be switched between an on-state and an off-state, wherein the sixth FET is configured to operate in the on-state when the second FET is in the off-state.

Numbered clause 48. The solid state switch of any of numbered clauses 42 to 47, wherein the first buffer is a UGB so as to reduce leakage at the first terminal of the first FET.

Numbered clause 49. The solid state switch of any of numbered clauses 42 to 48, wherein the first and second FET are both a first-type FET, wherein the first-type is n-type or p-type.

Numbered clause 50. The solid state switch of numbered clause 49, further comprising an electrical component for overvoltage protection, wherein the electrical component is arranged in series between the first and second FETs.

Numbered clause 51. The solid state switch of numbered clause 50, wherein the electrical component is a third FET, wherein the third FET is a second-type FET, wherein the second-type is p-type or n-type, wherein the first-type is different to the second-type.

Numbered clause 52. The solid state switch of any of numbered clauses 50 or 51, wherein the electrical component protects the solid state switch in applications where overvoltage conditions can cause damage to a device to which the switch is connected.

Numbered clause 53. The solid state switch of any of numbered clauses 42 to 52, wherein the solid state switch is a transmission-gate switch comprising the first FET in parallel with a third FET, wherein the third FET, comprises: a first terminal; a second terminal; a bulk terminal; and, a gate terminal, and the third FET is configured to be switched between an on-state and an off-state, wherein the third FET is a first-type FET, wherein the first FET is a second-type FET, wherein the first-type is n-type or p-type, wherein the second-type is p-type or n-type, wherein the first-type is different to the second-type.

Numbered clause 54. The solid state switch of numbered clause 53, wherein the voltage reference is a first voltage reference, the solid state switch further comprising: a seventh FET comprising a first terminal, a second terminal, a bulk terminal, and a gate terminal, and wherein the first terminal of the seventh FET is coupled to a second voltage reference, and the second terminal of the seventh FET is connected to the second terminal of the third FET, and optionally the bulk terminal of the seventh FET is coupled to the bulk terminal of the third FET.

Numbered clause 55. The solid state switch of numbered clause 54, wherein the seventh FET is configured to be switched between an on-state and an off-state, wherein the seventh FET is configured to operate in the on-state when the third FET is in the off-state.

Numbered clause 56. The solid state switch of any of numbered clauses 53 to 55, wherein the solid state switch further comprises a fourth FET in parallel with the second FET, wherein the fourth FET comprises: a first terminal; a second terminal; a bulk terminal; and, a gate terminal, and the fourth FET is configured to be switched between an on-state and an off-state, wherein the fourth FET is a third-type FET, wherein the second FET is a fourth-type FET, wherein the third-type is n-type or p-type, wherein the fourth-type is p-type or n-type, wherein the third-type is different to the fourth-type.

Numbered clause 57. The solid state switch of numbered clause 56, wherein the fourth FET is in series with the third FET, and wherein the second terminal of the third FET is connected to the second terminal of the fourth FET.

Numbered clause 58. The solid state switch of numbered clause 57, wherein the output terminal of the first buffer is coupled to the bulk terminal of the third FET, and the input terminal of the first buffer is coupled to the first terminal of the third FET.

Numbered clause 59. The solid state switch of any of numbered clauses 56 to 58, wherein the voltage reference is a first voltage reference, the solid state switch further comprising: an eighth FET comprising a first terminal, a second terminal, a bulk terminal, and a gate terminal, and wherein the first terminal of the eighth FET is coupled to a second voltage reference, and the second terminal of the eighth FET is connected to the second terminal of the fourth FET, and optionally the bulk terminal of the eighth FET is coupled to the bulk terminal of the fourth FET.

Numbered clause 60. The solid state switch of any of numbered clauses 42 to 59, wherein the first buffer is: a unity gain buffer, UGB; a voltage follower; or a cascade complementary source follower.

Numbered clause 61. A solid state switch, comprising:

> a first field-effect transistor, FET, comprising: a first terminal, a second terminal, a bulk terminal, and a gate terminal, and configured to be switched between an on-state and an off-state;
> a second FET in series with the first FET, wherein the second comprises: a first terminal, a second terminal, a bulk terminal, and a gate terminal, and wherein the second terminal of the first FET is coupled to the second terminal of the second FET;
> means for providing a current source to the bulk terminal of the first FET based on the voltage at the first terminal of the first FET; and
> means for providing a current source to the bulk terminal of the second FET based on the voltage at the first terminal of the second FET.

**Claims**

1. A solid state switch, comprising:

> a first field-effect transistor, FET, comprising: a first terminal, a second terminal, a bulk terminal and a gate terminal, and configured to be switched between an on-state and an off-state;
> a second FET in series with the first FET, wherein the second FET comprises a first terminal, a second terminal, a bulk terminal, and a gate terminal, and wherein the second terminal of the first FET is connected to the second terminal of the second FET; and,
> a first buffer comprising an output terminal coupled to the bulk terminal of the first FET, and an input terminal coupled to the first terminal of the first FET.

2. The solid state switch of claim 1, further comprising: a fifth FET comprising a first terminal, a second terminal, a bulk terminal, and a gate terminal, and wherein the first terminal of the fifth FET is coupled to a voltage reference, and the second terminal of the fifth FET is connected to the second terminal of the first FET, and optionally the bulk terminal of the fifth FET is coupled to the bulk terminal of the first FET.

3. The solid state switch of claim 2, wherein the fifth FET is configured to be switched between an on-state and an off-state, wherein the fifth FET is configured to operate in the on-state when the first FET is in the off-state.

4. The solid state switch of any preceding claim, further comprising a second buffer comprising an output terminal coupled to the bulk terminal of the second FET, and an input terminal coupled to the first terminal of the second FET.

5. The solid state witch of any preceding claim, further comprising: a sixth FET comprising a first terminal, a second terminal, a bulk terminal, and a gate terminal, and wherein the first terminal of the sixth FET is coupled to a voltage reference, and the second terminal of the sixth FET is connected to the second terminal of the second FET, and optionally the bulk terminal of the sixth FET is coupled to the bulk terminal of the second FET.

6. The solid state switch of claim 5, wherein the sixth FET is configured to be switched between an on-state and an off-state, wherein the sixth FET is configured to operate in the on-state when the second FET is in the off-state.

7. The solid state switch of any preceding claim, wherein the first buffer is a UGB so as to reduce leakage at the first terminal of the first FET.

8. The solid state switch of any preceding claim, wherein the first and second FET are both a first-type FET, wherein the first-type is n-type or p-type.

9. The solid state switch of claim 8, further comprising an electrical component for overvoltage protection, wherein the electrical component is arranged in series between the first and second FETs.

10. The solid state switch of claim 9, wherein the electrical component is a third FET, wherein the third FET is a second-type FET, wherein the second-type is p-type or n-type, wherein the first-type is different to the second-type.

11. The solid state switch of any of claims 9 or 10, wherein the electrical component protects the solid state switch in applications where overvoltage conditions can cause damage to a device to which the switch is connected.

12. The solid state switch of any preceding claim, wherein the solid state switch is a transmission-gate switch comprising the first FET in parallel with a third FET, wherein the third FET, comprises: a first terminal; a second terminal; a bulk terminal; and, a gate terminal, and the third FET is configured to be switched between an on-state and an off-state, wherein the third FET is a first-type FET, wherein the first FET is a second-type FET, wherein the first-type is n-type or p-type, wherein the second-type is p-type or n-type, wherein the first-type is different to the second-type.

13. The solid state switch of claim 12, wherein the voltage reference is a first voltage reference, the solid state switch further comprising:
a seventh FET comprising a first terminal, a second terminal, a bulk terminal, and a gate terminal, and wherein the first terminal of the seventh FET is coupled to a second voltage reference, and the second terminal of the seventh FET is connected to the second terminal of the third FET, and optionally the bulk terminal of the seventh FET is coupled to the bulk terminal of the third FET.

14. The solid state switch of claim 13, wherein the seventh FET is configured to be switched between an on-state and an off-state, wherein the seventh FET is configured to operate in the on-state when the third FET is in the off-state.

15. The solid state switch of any of claims 12 to 14, wherein the solid state switch further comprises a fourth FET in parallel with the second FET, wherein the fourth FET comprises: a first terminal; a second terminal; a bulk terminal; and, a gate terminal, and the fourth FET is configured to be switched between an on-state and an off-state, wherein the fourth FET is a third-type FET, wherein the second FET is a fourth-type FET, wherein the third-type is n-type or p-type, wherein the fourth-type is p-type or n-type, wherein the third-type is different to the fourth-type.

FIG. 1a

FIG. 1b

FIG. 2

FIG. 3

FIG. 4a

FIG. 4b

FIG. 5a

FIG. 5b

FIG. 5c

FIG. 6a

FIG. 6b

FIG. 7a

**FIG. 7b**

FIG. 8

FIG. 9

FIG. 10

FIG. 11

FIG. 12

Europäisches
Patentamt

European
Patent Office

Office européen
des brevets

# EUROPEAN SEARCH REPORT

**Application Number**

EP 25 15 9211

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 002 277 A (VULIH SALOMON [US] ET AL) 14 December 1999 (1999-12-14) * figures 1, 2 * | 1-15 | INV. H03K17/10 H03K17/687 H03K17/693 |
| A | US 2015/220473 A1 (HIGASHIDE TOMOFUMI [JP]) 6 August 2015 (2015-08-06) * figures 8, 9 * | 1-15 | |
| A | SU JIN JYH ET AL: "A Low-Leakage Body-Guarded Analog Switch in 0.35-$\mu\mbox{m}$ BiCMOS and Its Applications in Low-Speed Switched-Capacitor Circuits", IEEE TRANSACTIONS ON CIRCUITS AND SYSTEMS II: EXPRESS BRIEFS, IEEE, USA, vol. 62, no. 10, 1 October 2015 (2015-10-01), pages 947-951, XP011670317, ISSN: 1549-7747, DOI: 10.1109/TCSII.2015.2458093 [retrieved on 2015-09-25] * figure 2 * | 1-15 | |
| A | EP 4 009 523 A1 (NXP USA INC [US]) 8 June 2022 (2022-06-08) * figure 2 * | 1-15 | **TECHNICAL FIELDS SEARCHED (IPC)** H03K |

The present search report has been drawn up for all claims

| Place of search | Date of completion of the search | Examiner |
|---|---|---|
| The Hague | 26 June 2025 | Fermentel, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 9211

This annex lists the patent family members relating to the patent documents cited in the above-mentioned European search report.
The members are as contained in the European Patent Office EDP file on
The European Patent Office is in no way liable for these particulars which are merely given for the purpose of information.

26-06-2025

| Patent document cited in search report | | Publication date | Patent family member(s) | | Publication date |
|---|---|---|---|---|---|
| US 6002277 | A | 14-12-1999 | NONE | | |
| US 2015220473 | A1 | 06-08-2015 | JP | 2013153239 A | 08-08-2013 |
| | | | US | 2013194024 A1 | 01-08-2013 |
| | | | US | 2015220473 A1 | 06-08-2015 |
| EP 4009523 | A1 | 08-06-2022 | CN | 114614810 A | 10-06-2022 |
| | | | EP | 4009523 A1 | 08-06-2022 |
| | | | US | 11296716 B1 | 05-04-2022 |

EPO FORM P0459

For more details about this annex : see Official Journal of the European Patent Office, No. 12/82